# EUROPEAN PATENT APPLICATION

(11) **EP 1 318 543 A2**
(43) Date of publication of application: **11.06.2003**
(21) Application number: 02252534.9
(22) Date of filing: 09.04.2002
(51) Int. Cl.: H01L 21/8246, H01L 27/115

(54) **Semiconductor device and manufacturing method thereof**

(30) Priority: 07.12.2001 JP 2001374840
(71) Applicant: FUJITSU LIMITED, Kawasaki-shi, Kanagawa 211-8588 (JP)
(72) Inventor: Takahashi, Koji, c/o Fujitsu Limited, Kawasaki-shi, Kanagawa 211-8588 (JP); Yoshimura, Tetsuo, c/o Fujitsu Limited, Kawasaki-shi, Kanagawa 211-8588 (JP)
(74) Representative: Mohun, Stephen John

(57) **Abstract**

A resist pattern is formed-on a silicon oxide film. This resist pattern is formed in such a shape to expose only portions necessary for electrical insulation between bit lines adjacent to each other. In other words, here, these portions are a connection hole forming region in which a contact hole of the bit line is formed and a connection hole forming region in which a contact hole of a word line is formed. Using this resist pattern as a mask, an insulation region is formed by full anisotropic etching of the silicon oxide film. Siliciding is performed in this state and silicide is formed on a surface of the bit line exposed to the connection hole forming region and a surface of a source/drain in an active region of a peripheral circuit.

## Description

### CROSS-REFERENCE TO RELATED APPLICATIONS

This application is based upon and claims priority of Japanese Patent Application No. 2001-374840, filed on December 7, 2001, the contents being incorporated herein by reference.

### BACKGROUND OF THE INVENTION

### [Field of the Invention]

The present invention relates to a semiconductor device and a manufacturing method thereof in which bit lines are formed of an impurity diffused layer and word lines are formed to cross the bit lines via an insulation film having a charge-capture function or a floating gate.

### [Description of the Related Art]

Conventionally, as a nonvolatile memory which retains stored information even when a power source is cut off, such a semiconductor memory has been invented in which an impurity diffused layer formed on a semiconductor substrate forms bit lines (embedded bit lines), and word lines are formed on the semiconductor substrate via a capacity insulation film to cross the bit lines at right angles. Furthermore, semiconductor memories adaptable to further downsizing and miniaturizing of an element are hoped for.

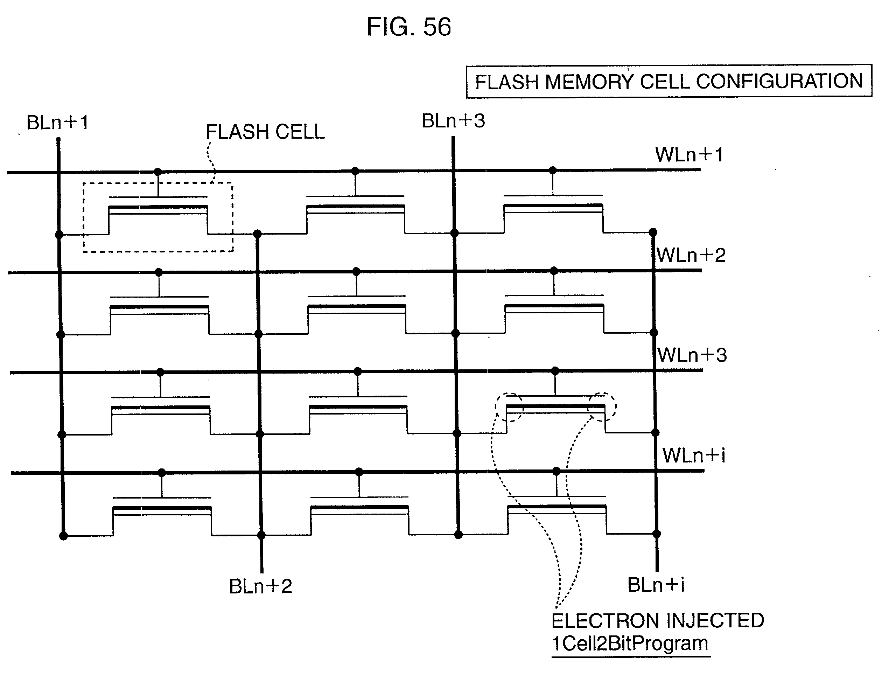

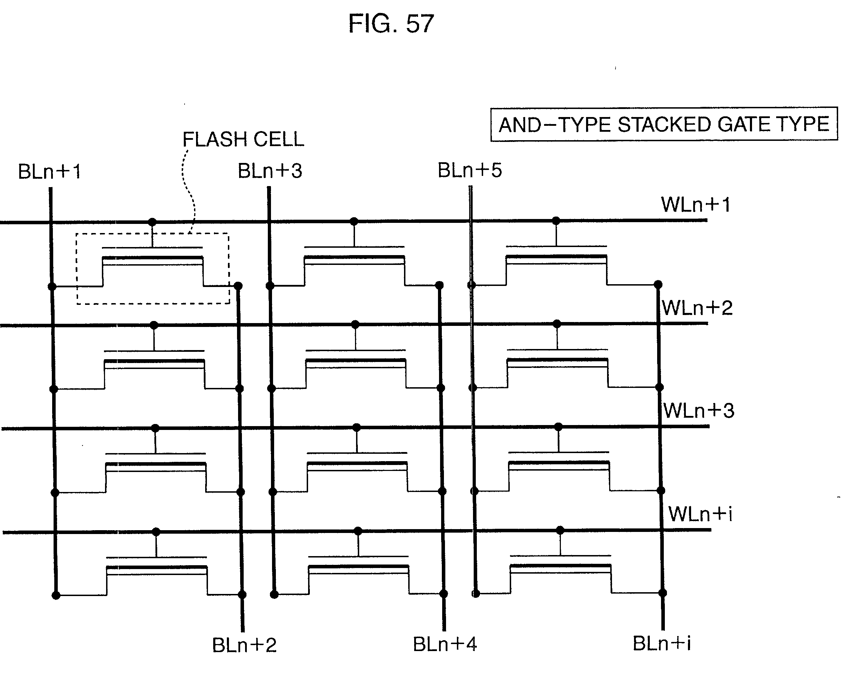

As an embedded-bid-line-type flash memory, the following semiconductor memories have been developed:
a so-called SONOS-type semiconductor memory which has, as an insulation film having a charge-capture function, an insulation film composed of a nitride film working as a charge-storage film and oxide films sandwiching the nitride film from its upper and bottom surfaces; and a floating-gate-type semiconductor memory including a floating-gate electrode disposed under the word lines via the insulation film. As the former type, there is a semiconductor memory which is structured as an NOR circuit (or an NAND circuit (not shown)) as shown in Fig. 56. As the latter type, there is a semiconductor memory which is structured as an AND circuit as shown in Fig. 57. Hereinafter, the former type semiconductor memory will be explained.

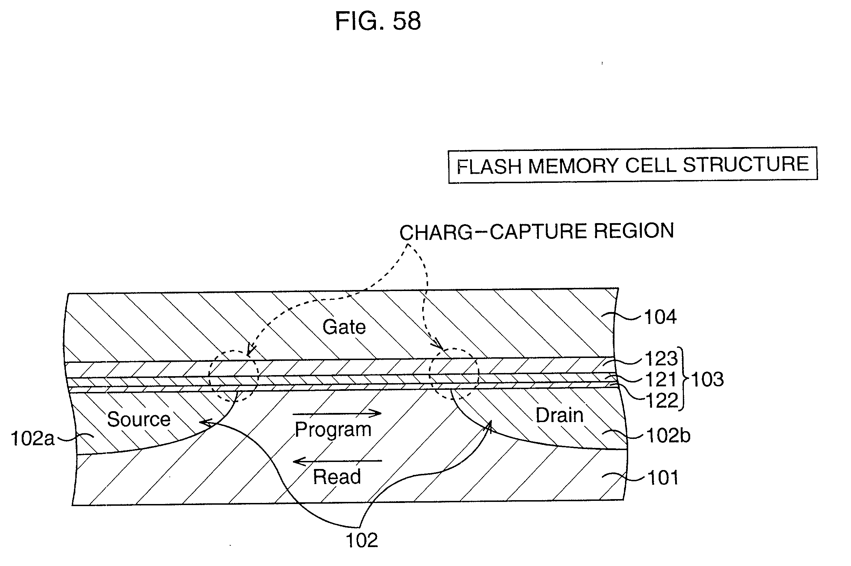

As shown in Fig. 58, this SONOS-type semiconductor memory is structured to include belt-shaped bit lines 102 (source 102a, drain 102b) which are formed by injecting an impurity to a silicon semiconductor substrate 101 by ion implantation and which function as sources/drains, and word lines 104 which are formed of a polycrystalline silicon film and cross the bit lines 102 above the bit lines 102 via an ONO film 103 (an insulation film composed of a nitride film 121 as a charge-storage film and oxide films 122 sandwiching the nitride film 121 from its upper and bottom surfaces).

In this semiconductor memory, in order to execute a program operation, electrons are injected to the nitride film 121 of the ONO film 103 or a junction interface between the nitride film 121 and the oxide film 122 of the ONO film 103 by channel hot electron (CHE) injection. Meanwhile, in order to execute an erase operation, holes are injected to the nitride film 121 of the ONO film 103 or the junction interface between the nitride film 121 and the oxide film 122 of the ONO film 103 by hole injection by band-to-band tunneling. Incidentally, depending on a voltage condition, a program operation by avalanche hot electron injection and an erase operation by avalanche hot hole injection or Fowler-Nordheim (FN) tunneling are also possible.

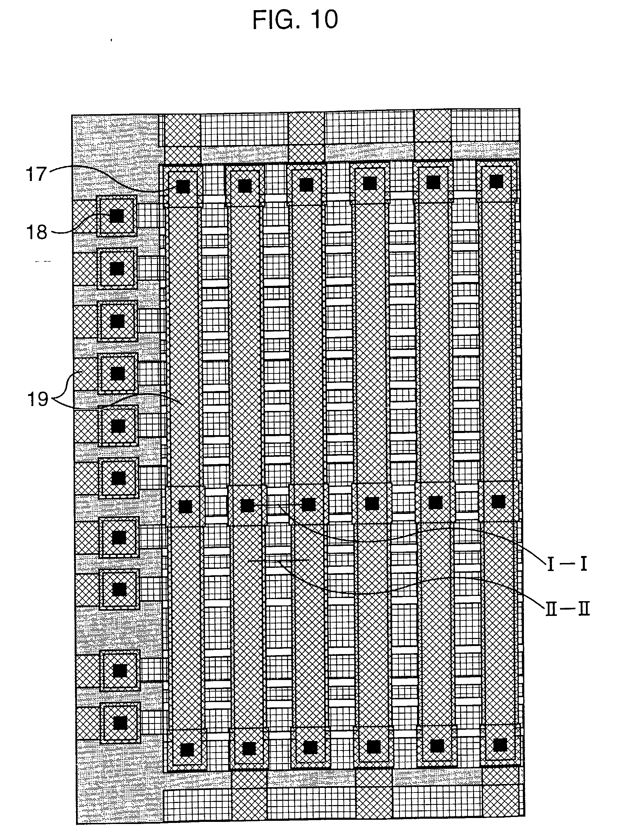

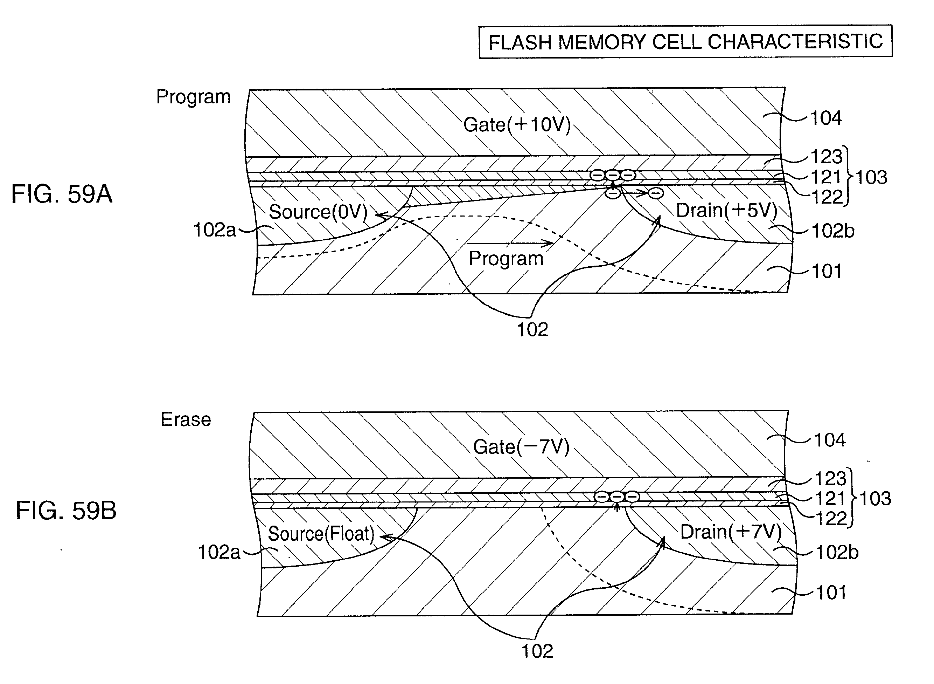

In order to execute the program operation by the CHE injection, as shown in Fig. 59A, 10 V is impressed on the word line (gate electrode) 104, 0 V to the source 102a, 5 V to the drain 102b respectively. At this time, the injected electrons are made captured in the nitride film 121 of the ONO film 103 or the junction interface between the nitride film 121 and the oxide film 122. In the shown example, the electrons are injected to an edge part of the drain 102b, but when the impressed voltages are switched between the source and the drain, the program operation can be executed by injection of the electrons to an edge part of the source 102a. In other words, the program operation can be executed in two places of one memory cell.

Meanwhile, when the erase operation is executed by the band-to-band tunneling, -7 V is impressed on the word line (the gate electrode) 104, a floating state to the source 102a, and 7 V to the drain 102b respectively. At this time, the holes are injected in the nitride film 121 of the ONO film 103 or the junction interface between the nitride film 121 and the oxide film 122. Consequently, when the electrons captured by the program operation exist, the holes and the electrons cancel each other to execute the erase operation. In the shown example, the holes are injected in the edge part of the drain 102b, but impressing the same voltage on the source 102a makes collective erase operation possible at the edge part of the source 102a at the same time with the edge part of the drain 102b.

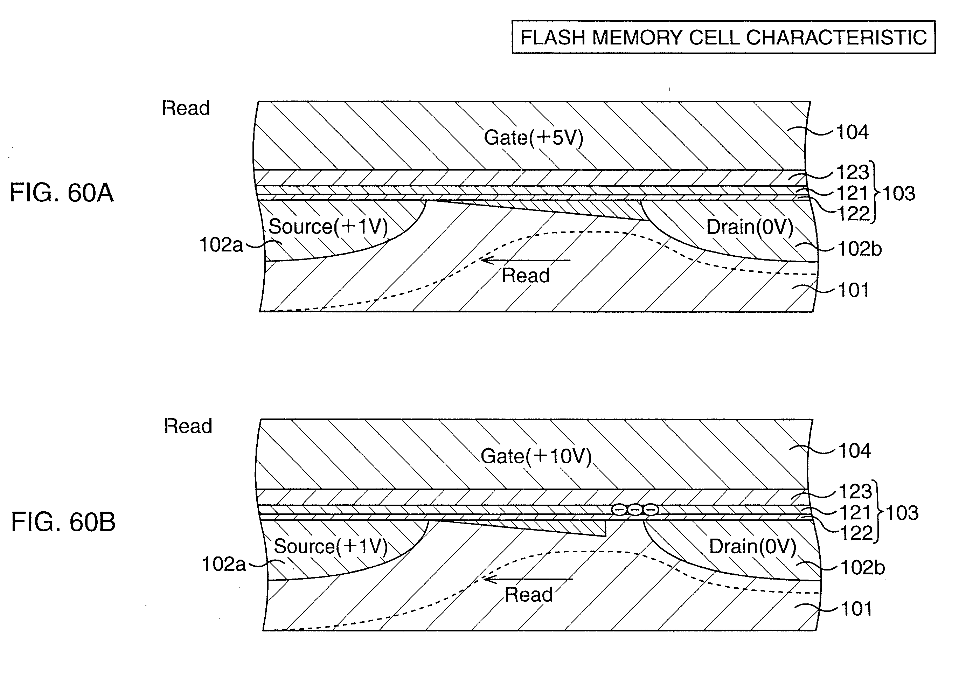

In order to read programmed data, a channel becomes conductive to pass an electric current therethrough when no electron exists in the nitride film 121 or the junction interface between the nitride film 121 and the oxide film 122, as shown in Fig. 60A. This state is designated as data "1". Meanwhile, when the electrons are captured in the nitride film 121 or the junction interface between the nitride film 121 and the oxide film 122 as shown in Fig. 60B, the channel is not conductive so that the electric current does not pass therethrough. This state is designated as data "0".

In recent years, in order to respond to a demand for realizing higher-speed driving of a semiconductor memory, metal-siliciding of wiring has been proposed not only in a memory cell region but also in a peripheral circuit region for the purpose of suppressing wiring delay.

When the wiring is metal-silicided, oxide film removing processing by dry etching is required as pre-processing of forming contact holes in an interlayer insulation film and forming metal wiring. This is because wet etching cannot secure selectivity to metal silicide.

When the oxide film removing processing is performed by the dry etching, it is required that the metal silicide is always formed on a base in which the contact holes are formed, since selectivity to a substrate cannot be secured and damage to the substrate cannot be ignored. However, when the entire base is covered with the metal silicide at the time of the dry etching to perform siliciding, there exists a problem that short circuit is caused between the bit lines in the memory cell region.

Embodiments of the present invention aim to provide a semiconductor device and a manufacturing method thereof which can realize higher-speed driving of a semiconductor memory by realizing metal-siliciding of bit lines and word lines while preventing short circuit and by suppressing wiring resistance, the semiconductor device being so structured that the bit lines are formed of an impurity diffused layer and the word lines are formed to cross the bit lines via an insulation film having a charge-capture function.

The invention is defined in the attached independent claims, to which reference should now be made. Further, preferred features may be found in the sub-claims appended thereto.

Embodiments of the present invention mainly concern a so-called SONOS-type transistor and a floating-gate-type transistor (an AND type of a two-layered silicon film).

In one aspect, a manufacturing method of a semiconductor device according to the present invention comprises the steps of: forming a bit line made of an impurity diffused layer by injecting an impurity to a surface layer of an active region of a semiconductor substrate; forming an insulation film having a charge-capture function to cover the active region; forming a word line on the semiconductor substrate via the insulation film by depositing a silicon film and a first metal silicide film on the insulation film and processing the silicon film, the first metal silicide film, and the insulation film; and forming an insulation region in advance at least between the bit lines adjacent to each other and forming a second metal silicide film on each exposed portion of the bit line to cause electrical insulation between the adjacent bit lines by the insulation region.

A form of a so-called siliciding in accordance with the present invention comprises the steps of: forming a bit line made of an impurity diffused layer by injecting an impurity to a surface layer of an active region of a semiconductor substrate; forming an insulation film having a charge-capture function to cover the active region; forming a word line on the semiconductor substrate via the insulation film by depositing a silicon film on the insulation film and processing the silicon film and the insulation film; and forming an insulation region in advance at least between the bit lines adjacent to each other and forming a metal silicide film on each exposed portion of the bit line and the word line to cause electrical insulation between the adjacent bit lines by the insulation region.

In another aspect, a semiconductor device according to the present invention comprises: a bit line made of an impurity diffused layer on a surface layer of a semiconductor substrate; and a word line crossing the bit line via an insulation film having a charge-capture function. In the semiconductor device, an insulation region is formed at least between the bit lines adjacent to each other, and a metal silicide film is formed on the word line and the bit line to cause electrical insulation between the adjacent bit lines by the insulation region.

Preferred embodiments of the present invention will now be described, by way of example only, with reference to the accompanying drawings, in which:
Fig. 1 is a diagrammatic plan view showing a manufacturing method of an SONOS-type flash memory according to a first embodiment of the present invention in the order of its processes;
Fig. 2 is a diagrammatic plan view showing the manufacturing method of the SONOS-type flash memory according to the first embodiment in the order of its processes, subsequently to Fig. 1;
Fig. 3 is a diagrammatic plan view showing the manufacturing method of the SONOS-type flash memory according to the first embodiment in the order of its processes, subsequently to Fig. 2;
Fig. 4 is a diagrammatic plan view showing the manufacturing method of the SONOS-type flash memory according to the first embodiment in the order of its processes, subsequently to Fig. 3;
Fig. 5 is a diagrammatic plan view showing the manufacturing method of the SONOS-type flash memory according to the first embodiment in the order of its processes, subsequently to Fig. 4;
Fig. 6 is a diagrammatic plan view showing the manufacturing method of the SONOS-type flash memory according to the first embodiment in the order of its processes, subsequently to Fig. 5;
Fig. 7A and Fig.7B are diagrammatic cross-sectional views taken along the lines I-I and II-II in Fig. 6 respectively;
Fig. 8 is a diagrammatic plan view showing a siliciding process in a modification example of the first embodiment;
Fig. 9 is a diagrammatic plan view showing a major process of a manufacturing method of an SONOS-type flash memory according to a previously considered method;
Fig. 10 is a diagrammatic plan view showing the major process of the manufacturing method of the SONOS-type flash memory according to the previously considered method, subsequently to Fig. 9;
Fig. 11A and Fig. 11B are diagrammatic cross-sectional views taken along the lines I-I and II-II in Fig. 10 respectively;
Fig. 12 is a diagrammatic plan view showing a major process of a manufacturing method of an SONOS-type flash memory according to a second embodiment;
Fig. 13 is a diagrammatic plan view showing the major process of the manufacturing method of the SONOS-type flash memory according to the second embodiment, subsequently to Fig. 12;
Fig. 14A and Fig. 14B are diagrammatic cross-sectional views taken along the lines I-I and II-II in Fig. 13 respectively;
Fig. 15 is a diagrammatic plan view showing a siliciding process in a modification example of the second embodiment;
Fig. 16 is a diagrammatic plan view showing a major process of a manufacturing method of an SONOS-type flash memory according to a third embodiment;
Fig. 17 is a diagrammatic plan view showing the major process of the manufacturing method of the SONOS-type flash memory according to the third embodiment, subsequently to Fig. 16;
Fig. 18A and Fig.18B are diagrammatic cross-sectional views taken along the lines I-I and II-II in Fig. 17 respectively;
Fig. 19 is a diagrammatic plan view showing a siliciding process in a modification example of the third embodiment;
Fig. 20 is a diagrammatic plan view showing a major process of a manufacturing method of an SONOS-type flash memory according to a fourth embodiment;
Fig. 21 is a diagrammatic plan view showing the major process of the manufacturing method of the SONOS-type flash memory according to the fourth embodiment, subsequently to Fig. 20;
Fig. 22 is a diagrammatic plan view showing the major process of the manufacturing method of the SONOS-type flash memory according to the fourth embodiment, subsequently to Fig. 21;
Fig. 23 is a diagrammatic plan view showing the major process of the manufacturing method of the SONOS-type flash memory according to the fourth embodiment, subsequently to Fig. 22;
Fig. 24 is a diagrammatic plan view showing the major process of the manufacturing method of the SONOS-type flash memory according to the fourth embodiment, subsequently to Fig. 23;
Fig. 25 is a diagrammatic plan view showing the major process of the manufacturing method of the SONOS-type flash memory according to the fourth embodiment, subsequently to Fig. 24;
FIG. 26 is a diagrammatic plan view showing the major process of the manufacturing method of the SONOS-type flash memory according to the fourth embodiment, subsequently to Fig. 25;
Fig. 27A and Fig. 27B are diagrammatic cross-sectional views taken along the lines I-I and II-II in Fig. 26 respectively;
FIG. 28 is a diagrammatic plan view showing a major process of a manufacturing method of an SONOS-type flash memory in a modification example 1 of the fourth embodiment;
Fig. 29 is a diagrammatic plan view showing the major process of the manufacturing method of the SONOS-type flash memory according to the modification example 1 of the fourth embodiment, subsequently to Fig. 28;
Fig. 30 is a diagrammatic plan view showing the major process of the manufacturing method of the SONOS-type flash memory according to the modification example 1 of the fourth embodiment, subsequently to Fig. 29;
Fig. 31 is a diagrammatic plan view showing the major process of the manufacturing method of the SONOS-type flash memory according to the modification example 1 of the fourth embodiment, subsequently to Fig. 30;
Fig. 32 is a diagrammatic plan view showing the major process of the manufacturing method of the SONOS-type flash memory according to the modification example 1 of the fourth embodiment, subsequently to Fig. 31;
Fig. 33 is a diagrammatic plan view showing the major process of the manufacturing method of the SONOS-type flash memory according to the modification example 1 of the fourth embodiment, subsequently to Fig. 32;
Fig. 34 is a diagrammatic plan view showing the major process of the manufacturing method of the SONOS-type flash memory according to the modification example 1 of the fourth embodiment, subsequently to Fig. 33;
Fig. 35 is a diagrammatic cross-sectional view taken along the line I-I in Fig. 34;
Fig. 36 is a diagrammatic plan view showing a major process of a manufacturing method of an SONOS-type flash memory according to a modification example 2 of the fourth embodiment;
Fig. 37 is a diagrammatic plan view showing the major process of the manufacturing method of the SONOS-type flash memory according to the modification example 2 of the fourth embodiment, subsequently to Fig. 36;
Fig. 38 is a diagrammatic plan view showing the major process of the manufacturing method of the SONOS-type flash memory according to the modification example 2 of the fourth embodiment, subsequently to Fig. 37;
Fig. 39 is a diagrammatic plan view showing the major process of the manufacturing method of the SONOS-type flash memory according to the modification example 2 of the fourth embodiment, subsequently to Fig. 38;
Fig. 40 is a diagrammatic plan view showing the major process of the manufacturing method of the SONOS-type flash memory according to the modification example 2 of the fourth embodiment, subsequently to Fig. 39;
Fig. 41 is a diagrammatic plan view showing the major process of the manufacturing method of the SONOS-type flash memory according to the modification example 2 of the fourth embodiment, subsequently to Fig. 40;
Fig. 42 is a diagrammatic plan view showing the major process of the manufacturing method of the SONOS-type flash memory according to the modification example 2 of the fourth embodiment, subsequently to Fig. 41;
Fig. 43 is a diagrammatic cross-sectional view taken along the line I-I in Fig. 42;
Fig. 44 is a diagrammatic plan view showing a final process of a manufacturing method of an SONOS-type flash memory according to a modification example 3 of the fourth embodiment;
Fig. 45A, Fig. 45B, Fig. 45C, and Fig. 45D are schematic views illustrative of one example of comparison of the resistivity of word lines and bit lines in the modification example 3 of the fourth embodiment with that in the conventional example;
Fig. 46 is a diagrammatic plan view showing a manufacturing method of a floating-gate-type flash memory according to a fifth embodiment;
Fig. 47A, Fig. 47B, and Fig. 47C are diagrammatic plan views showing the manufacturing method of the floating-gate-type flash memory according to the fifth embodiment, subsequently to Fig. 46;
Fig. 48A, Fig. 48B, and Fig. 48C are diagrammatic plan views showing the manufacturing method of the floating-gate-type flash memory according to the fifth embodiment, subsequently to Fig. 47A, Fig. 47B, and Fig. 47C;
Fig. 49A, Fig. 49B, and Fig. 49C are diagrammatic plan views showing the manufacturing method of the floating-gate-type flash memory according to the fifth embodiment, subsequently to Fig. 48A, Fig. 48B, and Fig. 48C;
Fig. 50A and Fig. 50B are diagrammatic plan views showing the manufacturing method of the floating-gate-type flash memory according to the fifth embodiment, subsequently to Fig. 49A, Fig. 49B, and Fig. 49C;
Fig. 51 is a diagrammatic plan view showing the manufacturing method of the floating-gate-type flash memory according to the fifth embodiment, subsequently to Fig. 50A and Fig. 50B;
Fig. 52 is a diagrammatic plan view showing the manufacturing method of the floating-gate-type flash memory according to the fifth embodiment, subsequently to Fig. 51;
Fig. 53 is a diagrammatic plan view showing a manufacturing method of a floating-gate-type flash memory according to a sixth embodiment;
Fig. 54 is a diagrammatic plan view showing the manufacturing method of the floating-gate-type flash memory according to the sixth embodiment, subsequently to Fig. 53;
Fig. 55 is a diagrammatic plan view showing the manufacturing method of the floating-gate-type flash memory according to the sixth embodiment, subsequently to Fig. 54;
Fig. 56 is an equivalent circuit diagram showing a circuit configuration of the SONOS-type flash memory;
Fig. 57 is an equivalent circuit diagram showing a circuit configuration of the floating-gate-type flash memory;
Fig. 58 is a diagrammatic cross-sectional view showing a memory cell structure of the SONOS-type flash memory;
Fig. 59A and Fig. 59B are diagrammatic cross-sectional views illustrative of a program method of the SONOS-type flash memory; and
Fig. 60A and Fig. 60B are diagrammatic cross-sectional views illustrative of a reading method of the SONOS-type flash memory.

### DETAILED DESCRIPTION OF THE PREFERRED EMBODIMENTS

### -First Embodiment-

In this embodiment, a so-called embedded-bit-line-type flash memory (an SONOS-type flash memory) is shown as an example of a semiconductor device. The structure of the flash memory is explained together with its manufacturing processes here for convenience' sake.

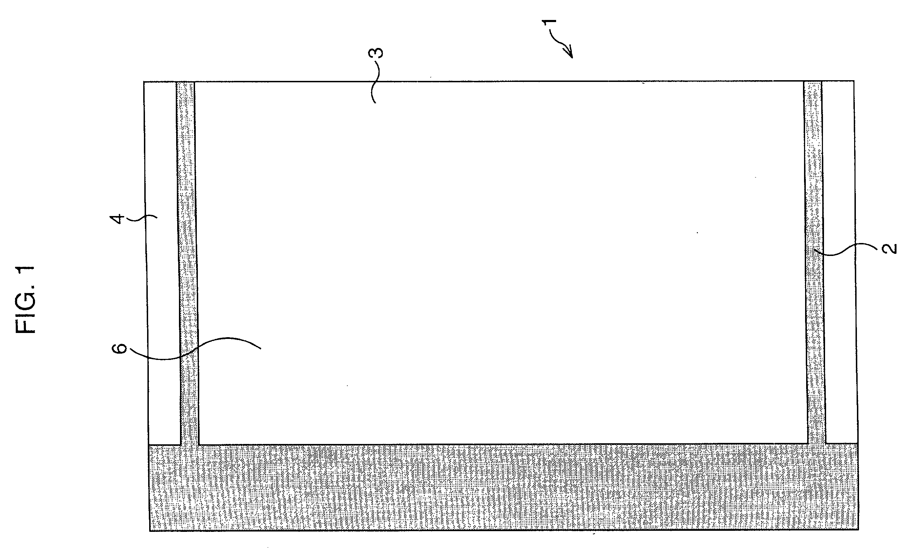

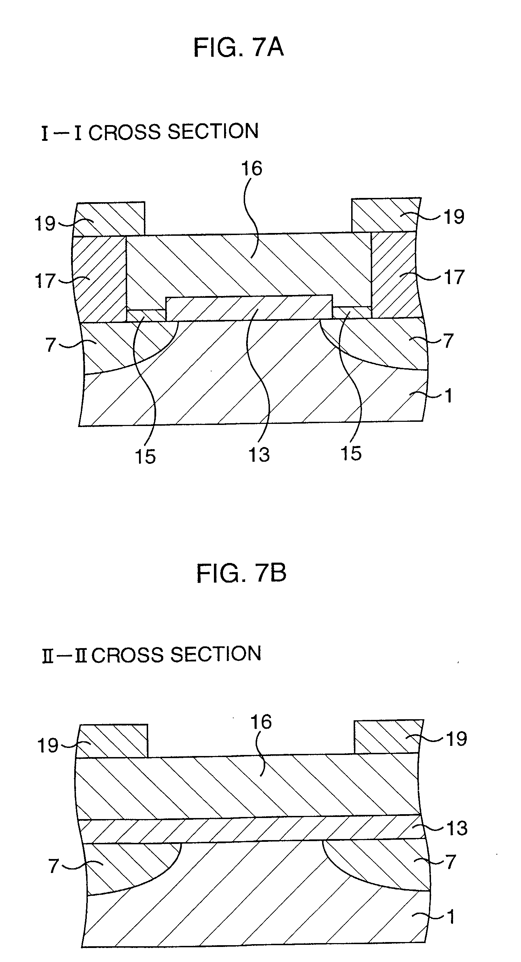

Fig. 1 to Fig. 6 are diagrammatic plan views showing a manufacturing method of an SONOS-type flash memory according to a first embodiment in the order of its processes, and Fig. 7A and Fig. 7B are diagrammatic sectional views of the same.

In order to manufacture this flash memory, as shown in Fig. 1, a p-type silicon semiconductor substrate 1 is first prepared. On the surface of this semiconductor substrate 1, a field oxide film 2 with a film thickness of about 200 nm to about 500 nm is formed in an element separation region through thermal oxidation at a temperature of 900 °C to 1000 °C, for example, by a LOCOS method. Thereby, element separation is caused and an active region 3 of a memory cell and an active region 4 of a peripheral circuit where a CMOS transistor and so on are formed are demarcated.

In this case, instead of using the LOCOS method, a so-called STI element separating method, in which a trench (not shown) is formed in the element separation region of the semiconductor substrate 1 and an insulator is filled to the trench, may be used to demarcate the active regions.

Subsequently, an ONO film 6 which has a three-layered structure composed of an upper silicon oxide film, a silicon nitride film, and a lower silicon oxide film is formed on the semiconductor substrate 1.

More specifically, the lower silicon oxide film having a film thickness of about 5 nm to about 10 nm is first formed on the semiconductor substrate 1 by thermal oxidation at a temperature of 800 °C to 1100 °C. Next, the silicon nitride film having a film thickness of about 12 nm to about 16 nm is formed on the lower silicon oxide film by a CVD method at a temperature of 600 °C to 800 °C. Then, the upper silicon oxide film having a film thickness of about 5 nm to about 10 nm is formed on the silicon nitride film by wet oxidation at a temperature of 1000 °C to 1100 °C. These three layers constitute the ONO film 6. Incidentally, when the silicon nitride film is thinned, it is also possible to form the upper silicon oxide film by the CVD method.

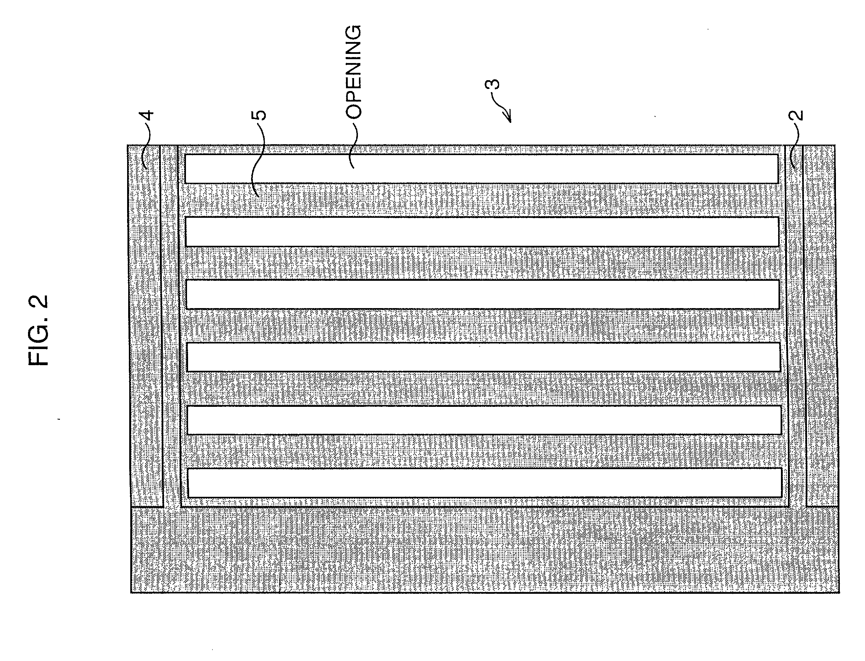

Subsequently, as shown in Fig. 2, the entire surface is coated with a resist, and a resist pattern 5 having a plurality of belt-shaped openings is formed in the active region 3 of the memory cell by lithography. Using this resist pattern 5 as a mask, an n-type impurity, arsenic (As) here, is ion-implanted under the condition of a dose amount of 1 x 10¹⁵ to 5 x 10¹⁵ (/cm²) and acceleration energy of 50 (keV) to 90 (keV). Thereby, embedded bit lines 7 which become sources/drains are formed on the surface layer of the semiconductor substrate 1.

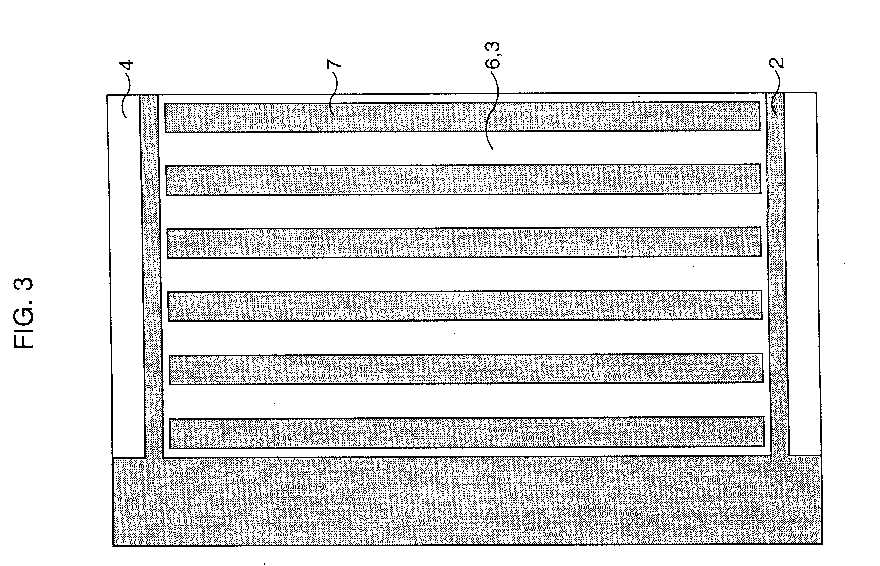

Next, as shown in Fig. 3, the resist pattern 5 is removed by ashing treatment or the like using oxygen plasma.

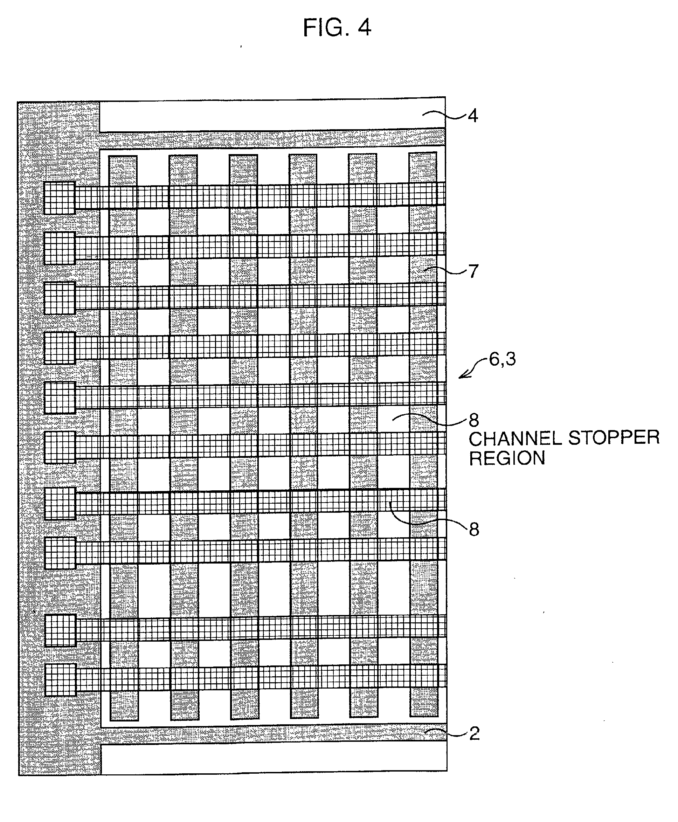

Subsequently, as shown in Fig. 4, the ONO film 6 in the active region 4 of the peripheral circuit is removed and the ONO film 6 is left only in the active region 3 of the memory cell. Thereafter, a gate insulation film (not shown) is formed in the active region 4 of the peripheral circuit.

Subsequently, amorphous silicon doped with phosphorus (P) whose concentration is 3 x 10²¹ (cm³) is deposited on the entire surface by the CVD method until it has a film thickness of about 100 nm to about 150 nm. Tungsten silicide is deposited on this amorphous silicon by the CVD method until it has a film thickness of about 150 nm to about 180 nm. Then, a resist pattern (not shown) in an electrode shape is formed. Using this resist pattern as a mask, the tungsten silicide and the amorphous silicon are dry-etched using HCl/O₂ gas and the like as etching gas. In this way, word lines 8 crossing (in this embodiment, crossing at right angles) the bit lines 7 via the ONO film 6 are formed in the active region 3 of the memory cell, and gate electrodes (not shown) are formed in the active region 4 of the peripheral circuit on the semiconductor substrate 1 via the gate insulation film, respectively.

Subsequently, after ashing removal is performed for the resist pattern, a resist pattern (not shown) with only n-type transistor regions of the active region 4 of the peripheral circuit left open is formed. Using the gate electrodes as masks, an n-type impurity, arsenic here, is ion-implanted to the surface layer of the semiconductor substrate 1 under the condition of a dose amount of 1 x 10¹³ to 3 x 10¹³ (/cm²) and acceleration energy of 50 to 70 (keV) to form n-type LDDs. Next, a resist pattern (not shown), this time with only p-type transistor regions (n-type wells) of the active region 4 of the peripheral circuit left open is formed. Using the gate electrodes as masks, a p-type impurity, boron (B) here, is ion-implanted to the surface layer of the semiconductor substrate 1 under the condition of a dose amount of 3 x 10¹³ to 7 x 10¹³ (/cm²) and acceleration energy of 20 to 30 (keV) to form p-type LDDs.

Subsequently, after ashing removal is performed for the resist pattern, a resist pattern (not shown) with only the active region 3 of the memory cell left open is formed. Using this resist pattern as a mask, boron (B) is ion-implanted under the condition of a dose amount of 3 x 10¹² to 3 x 10¹³ (/cm²) and acceleration energy of 50 (keV) to 80 (keV) to form channel stopper regions 9 between the adjacent bit lines 7 on the surface layer of the semiconductor substrate 1. Incidentally, at this time, the boron is not ion-implanted to the active region 4 of the peripheral circuit since it is covered with the resist pattern. On the other hand, the boron is ion-implanted to the bit lines 7. However, since impurity concentration differs by two-digits or more, no practical influence is given to them.

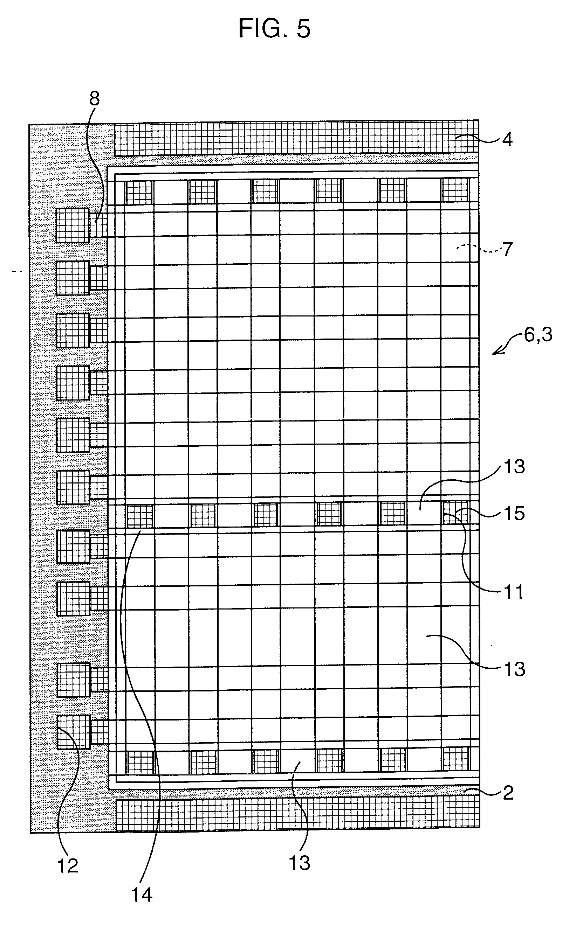

Subsequently, as shown in Fig. 5, after ashing removal is performed for the resist pattern, a silicon oxide film is deposited on the entire surface by the CVD method, and on this silicon oxide film, a resist pattern (not shown) which is shaped to cover portions necessary for electrical insulation between the adjacent bit lines 7 and to leave metal silicide forming portions open is formed. In other words, here, this resist pattern is shaped to expose only connection hole forming regions 11 where contact holes of the bit lines 7 are formed and connection hole forming regions 12 where contact holes of the word lines 8 are formed. Thereafter, using this resist pattern as a mask, the silicon oxide film is full-anisotropically etched.

Then, ashing removal is performed for the resist pattern. Thereby, a guard film 13, which is made of the silicon oxide film, having the connection hole forming regions 11, 12 in which portions of the bit lines 7 are exposed is formed in the active region 3 of the memory cell. At the same time, side walls 14 are formed on side walls of the word lines 8 facing end portions of the connection hole forming regions 11, 12. In this way, insulation regions are constituted of the guard film 13 and the side walls 14. At this time, side walls (not shown) are also formed on side walls of the gate electrodes in the active region 4 of the peripheral circuit. Incidentally, instead of forming the side walls 14, it is possible to leave the guard film 13 in portions corresponding to the side walls 14 by a resist pattern.

Subsequently, a resist pattern (not shown) with only the n-type transistor regions of the active region 4 of the peripheral circuit left open is formed. Using the gate electrodes and the side walls as masks, an n-type impurity, arsenic here, is ion-implanted to the surface layer of the semiconductor substrate 1 under the condition of a dose amount of 3 x 10¹⁵ to 5 x 10¹⁵ (/cm²) and acceleration energy of 50 to 70 (keV) to form n-type sources/drains. Next, a resist pattern (not shown), this time with only the p-type transistor regions (n-type wells) of the active region 4 of the peripheral circuit left open is formed. Using the gate electrodes and the side walls as masks, a p-type impurity, boron (B) here, is ion-implanted to the surface layer of the semiconductor substrate 1 under the condition of a dose amount of 3 x 10¹⁵ to 5 x 10¹⁵ (/cm²) and acceleration energy of 30 to 50 (keV) to form p-type sources/drains.

Furthermore, the oxide film formed on the surface of the bit lines 7 which are exposed in the connection hole forming regions 11 and the oxide film formed on the surfaces of the sources/drains in the active region 4 of the peripheral circuit are removed by hydrofluoric acid treatment. At this time, portions under the insulation regions (under the guard film 13 and the side walls 14 in the active region 3 of the memory cell) and portions under the side walls in the active region 4 of the peripheral circuit are not influenced by the hydrofluoric acid treatment.

Thereafter, titanium (Ti) is deposited on the entire surface by a sputtering method until it has a film thickness of about 20 nm to about 50 nm. Then, it is silicided by rapid anneal treatment (RTA) at a temperature of 650 °C to 750 °C. Thereby, titanium silicides 15 are formed on the surfaces of the bit lines 7 exposed in the connection hole forming regions 11 and on the surfaces of the sources/drains in the active region 4 of the peripheral circuit (only the active region 3 of the memory cell is shown here).

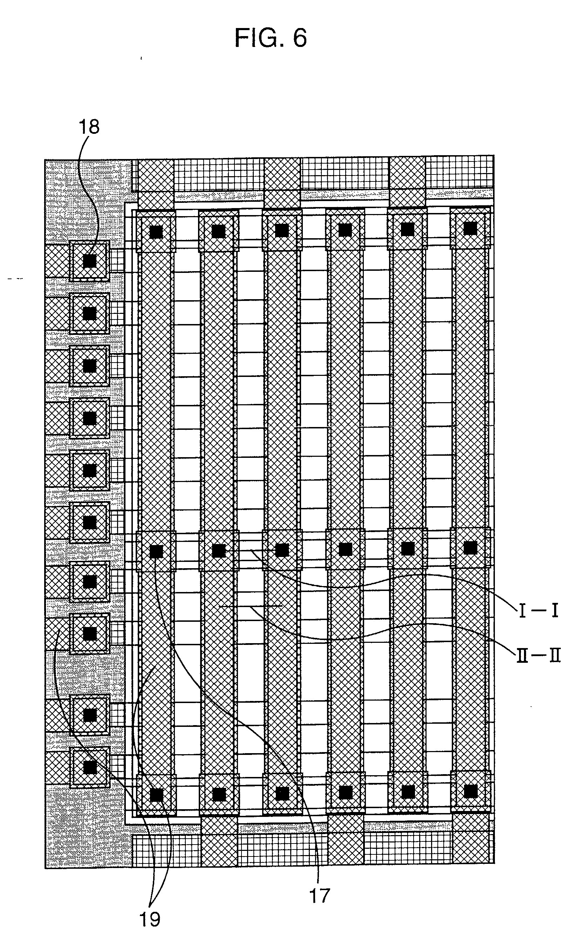

Subsequently, as shown in Fig. 6, Fig. 7A, and Fig. 7B (Fig. 7A shows a cross section taken along the line I-I in Fig. 6 and Fig. 7B shows a cross section taken along the line II-II in Fig. 6), after an interlayer insulation film 16 is formed on the entire surface by the CVD method, contact holes 17, 18 are formed in portions of the interlayer insulation film 16 which correspond to the connection hole forming regions 11, 12.

Subsequently, oxide film removing processing by dry etching is performed for the exposed portions of the titanium silicides 15 in the active regions 3, 4 as pre-processing of a wiring forming process. Thereafter, a metal film made of an Al alloy or the like is formed by a sputtering method. By patterning of this metal film, metal wiring 19 is formed, which is connected to the bit lines 7 and the word lines 8 (also to the gate electrodes, the sources/drains in the active region 4 of the peripheral circuit) via the contact holes 17, 18 and with which the bit lines 7 are backed.

Thereafter, after an interlayer insulation film, contact holes (via holes), a wiring layer, and so on are further formed, the SONOS-type flash memory is finished.

According to this embodiment, in the active region 3 of the memory cell, insulation between the word lines 8 and the titanium silicides 15 in the connection hole forming regions 11 is ensured by the side walls 14. Moreover, as shown in Fig. 7A and Fig. 7B, the guard film 13 is formed between the adjacent bit lines 7 to ensure insulation. Therefore, the memory cell region and its peripheral circuit region are silicided without short-circuit being caused between the adjacent bit lines 7 by the titanium silicides 15 and wiring resistance is suppressed. Thereby, higher-speed driving of the so-called SONOS-type flash memory can be realized.

### -Modification Example-

A modification example of the first embodiment will be explained here. A manufacturing method of an SONOS-type flash memory in this modification example is different from that in the first embodiment in that saliciding is performed. Note that the same reference numerals and symbols are used to designate the same components and so on as those explained in the first embodiment, and therefore, the explanation thereof will be omitted.

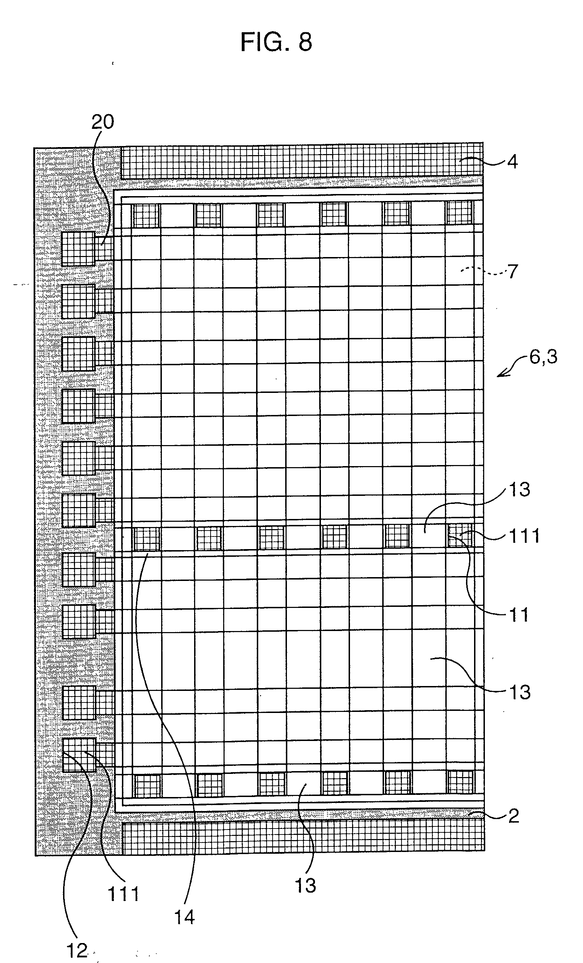

Fig. 8 is a diagrammatic plan view showing a saliciding process in the modification example of the first embodiment.

After each process in Fig. 1 to Fig. 3 similarly to the above-described first embodiment, in the process corresponding to Fig. 4, a silicon nitride film is first formed by a plasma CVD method on the amorphous silicon, which is deposited at the time the word lines (and the gate electrodes in the active region 4) are formed. Thereby, the word lines 20 are formed without forming metal silicide on the amorphous silicon.

Subsequently, as shown in Fig. 8, the guard film 13 and the side walls 14 are formed after the same process as that in Fig. 5 in the first embodiment. Thereafter, the silicon nitride film exposed in portions on the word lines 20 in the active region 3 and on the gate electrodes of the active region 4 are removed by phosphoric acid boiling. Subsequently, the oxide film exposed in portions on the bit lines 7 in the active region 3 and on the sources/drains in the active region 4 are removed by hydrofluoric acid treatment.

Subsequently, on the entire surface, cobalt (Co) is deposited until it has a film thickness of about 5 nm to about 10 nm, and TiN is deposited until it has a film thickness of about 20 nm to about 50 nm by a sputtering method. They are silicided by rapid anneal treatment (RTA) at a temperature of 450 °C to 550 °C. Thereby, cobalt silicides 111 are formed on the surfaces of the bit lines 7 exposed in the connection hole forming regions 11, the surfaces of the word lines 20 exposed in the connection hole forming regions 12, and on the gate electrodes and the surfaces of the sources/drains in the active region 4 of the peripheral circuit (only the active region 3 of the memory cell is shown here).

Thereafter, after the same processes as those in Fig. 6, Fig. 7A, and Fig. 7B, the SONOS-type flash memory is finished.

According to this modification example, in the active region 3 of the memory cell, insulation between the word lines 20 and the cobalt silicides 111 in the connection hole forming regions 11 is ensured by the side walls 14. Moreover, the guard film 13 is formed between the adjacent bit lines 7 to ensure insulation. Therefore, the memory cell region and its peripheral circuit region are salicided without short-circuit being caused between the adjacent bit lines 7 by the cobalt silicides 111 and wiring resistance is suppressed. Thereby, higher-speed driving of the so-called SONOS-type flash memory can be realized. In addition, a so-called dual gate is made possible through the use of the saliciding process, and a low-voltage operation can be realized by lowering a threshold (Vth).

### -Comparison Example-

A manufacturing method of an SONOS-type flash memory in which siliciding is performed by a conventional method is shown as a comparison example of the present invention. Note that the same reference numerals and symbols are used to designate the same components and so on as those explained in the first embodiment, and therefore, the explanation thereof will be omitted.

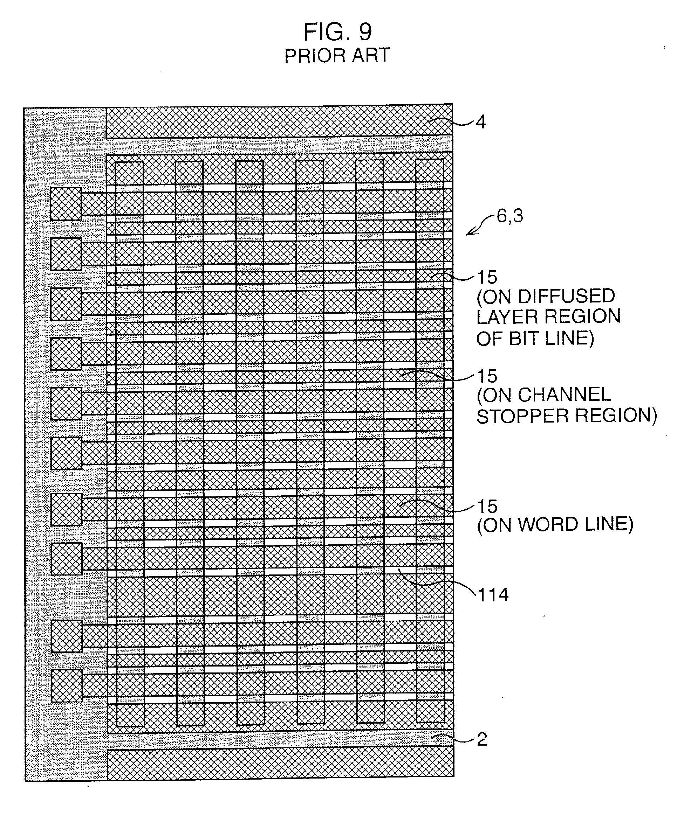

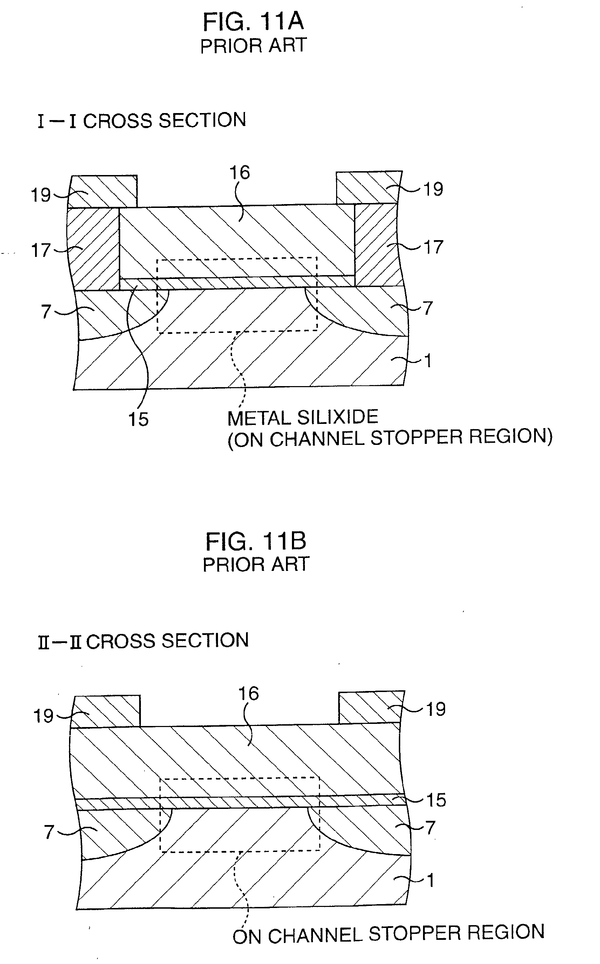

Fig. 9 and Fig. 10 are diagrammatic plan views showing major processes of the previously known manufacturing method of the SONOS-type flash memory, and Fig. 11A and Fig. 11B are diagrammatic cross-sectional views of the same.

After each process in FIG. 1 to FIG. 4 similarly to the above-described first embodiment, a silicon oxide film is first deposited on the entire surface by a CVD method. This silicon oxide film is full-anisotropically etched. Thereby, as shown in Fig. 9, side walls 114 are formed on the side walls of the word lines 8 in the active region 3 of the memory cell. In the active region 4 of the peripheral circuit, side walls (not shown) are formed on the side walls of the gate electrodes. These side walls are for preventing short-circuit between the word lines 8 (gate electrodes) due to siliciding.

Subsequently, the oxide film is removed by hydrofluoric acid treatment. Thereafter, titanium (Ti) is deposited on the entire surface by a sputtering method until it has a film thickness of about 20 nm to about 50 nm. It is silicided by rapid anneal treatment (RTA) at a temperature of 650 °C to 750 °C. Thereby, the titanium silicides 15 are formed between the word lines 8 with the side walls 114 therebetween in the active region 3 and between the gate electrodes with the side walls therebetween in the active region 4.

Thereafter, as shown in Fig. 10, Fig. 11A, and Fig. 11B (Fig. 11A shows a cross section taken along the line I-I in Fig. 10 and Fig. 11B shows a cross section taken along the line II-II in Fig. 10), the metal wiring 19 is formed, which is connected to the bit lines 7 and the word lines 8 (also to the gate electrodes, the sources/drains in the active region 4 of the peripheral circuit) via the contact holes 17, 18 and with which they are backed.

However, in this case, the titanium silicides 15 are formed to cover the regions between the adjacent bit lines 7 in the active region 3 of the memory cell, as shown in Fig. 11A and Fig. 11B. Consequently, short-circuit is inevitably caused between the bit lines 7. Therefore, it is difficult to manufacture an SONOS-type flash memory which are durable in practical use by this method.

### -Second Embodiment-

Next, a second embodiment of the present invention will be explained. A manufacturing method of an SONOS-type flash memory in this second embodiment is substantially the same as that in the first embodiment. However, it is different in the shape of the guard film at the time when the bit lines are silicided. Note that the same reference numerals and symbols are used to designate the same components and so on as those explained in the first embodiment, and therefore, the explanation thereof will be omitted.

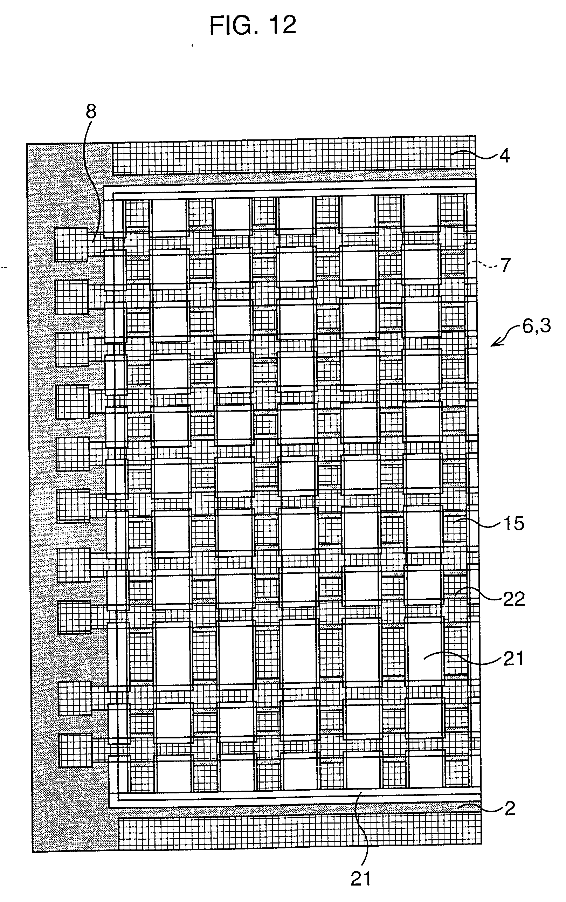

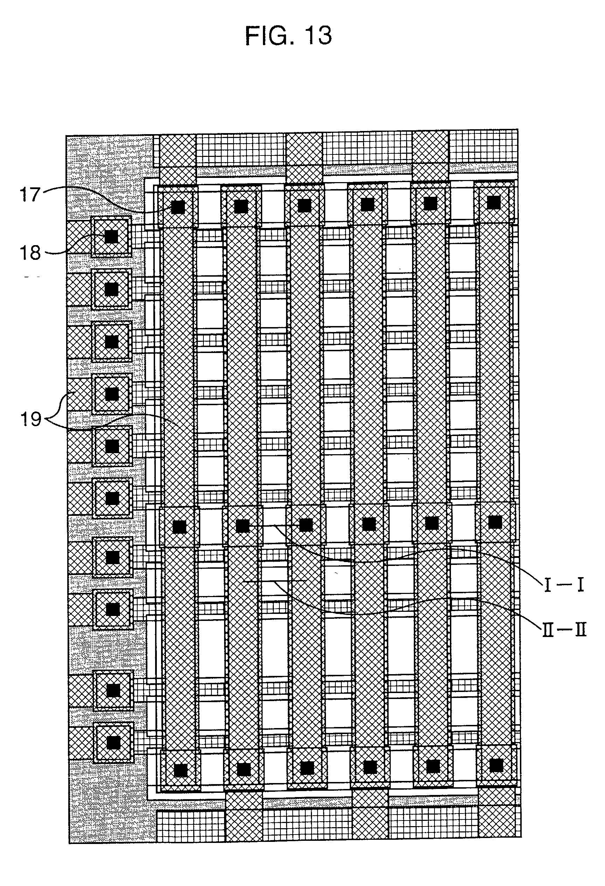

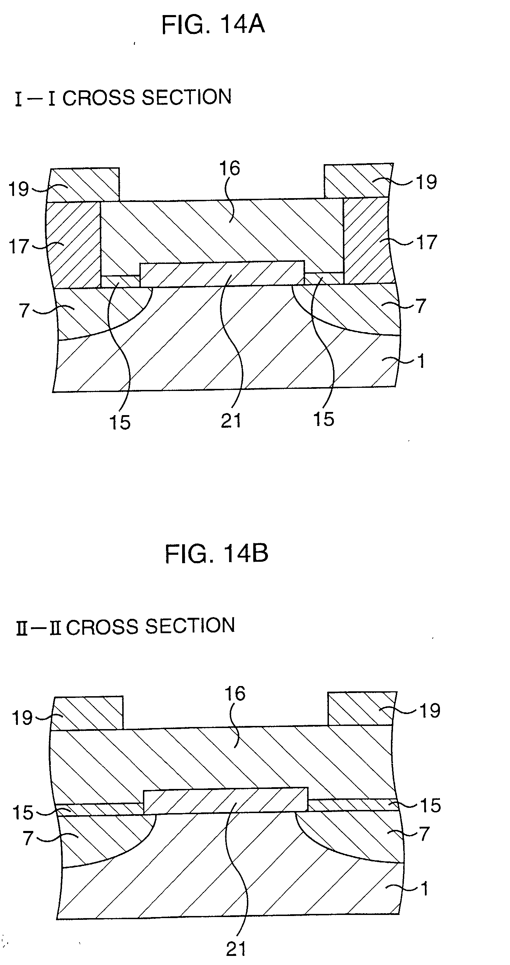

Fig. 12 and Fig. 13 are diagrammatic plan views showing major processes of the manufacturing method of the SONOS-type flash memory according to the second embodiment, and Fig. 14 is a diagrammatic cross-sectional view of the same.

After each process in Fig. 1 to Fig. 3 similarly to the above-described first embodiment, a silicon oxide film is first deposited on the entire surface by a CVD method. Thereafter, as shown in Fig. 12, on this silicon oxide film, a latticed resist pattern (not shown) which is shaped to cover portions necessary for electrical insulation between the adjacent bit lines 7 and to leave metal silicide forming portions open is formed. In other words, here, this resist pattern is shaped to expose portions on the bit lines 7 and the word lines 8 in longitudinal directions respectively. Using this resist pattern as a mask, the silicon oxide film is full-anisotropically etched.

Then, ashing removal is performed for the resist pattern. Thereby, a guard film 21, which is composed of a plurality of matrix silicon oxide films, covering the active region 3 with portions on the bit lines 7 and the word lines 8 exposed in the longitudinal directions respectively is formed in the active region 3 of the memory cell. At the same time, side walls 22 are formed on the side walls of the word lines 8 exposed from the guard film 21. In this way, insulation regions are constituted of the guard film 21 and the side walls 22. At this time, side walls (not shown) are also formed on the side walls of the gate electrodes in the active region 4 of the peripheral circuit.

Thereafter, titanium (Ti) is deposited on the entire surface by a sputtering method until it has a film thickness of about 20 nm to about 50 nm. Then, it is silicided by rapid anneal treatment (RTA) at a temperature of 650 °C to 750 °C. Thereby, the titanium silicides 15 are formed on the surfaces of the bit lines 7 exposed between the guard films 21 via the side walls 22 and on the surfaces of the sources/drains in the active region 4 of the peripheral circuit (only the active region 3 of the memory cell is shown here).

Subsequently, as shown in Fig. 13, Fig. 14A, and Fig. 14B (Fig. 14A shows a cross section taken along the line I-I in Fig. 13 and Fig. 14B shows a cross section taken along the line II-II in Fig. 13), after the interlayer insulation film 16 is formed on the entire surface by the CVD method, the contact holes 17, 18 are formed in the portions of the interlayer insulation film 16 which correspond to the connection hole forming regions.

Subsequently, oxide film removing processing by dry etching is performed for the exposed portions of the titanium silicides 15 in the active regions 3, 4 as the pre-processing of the wiring forming process. Thereafter, a metal film made of an Al alloy or the like is formed by the sputtering method. By patterning of this metal film, the metal wiring 19 is formed, which is connected to the bit lines 7 and the word lines 8 (also to the gate electrodes, the sources/drains in the active region 4 of the peripheral circuit) via the contact holes 17, 18 and with which the bit lines 7 are backed.

Thereafter, after an interlayer insulation film, contact holes (via holes), a wiring layer, and so on are further formed, the SONOS-type flash memory is finished.

According to this embodiment, in the active region 3 of the memory cell, insulation between the word lines 8 exposed from the guard film 21 and the titanium silicides 15 is ensured by the side walls 22. Moreover, as shown in Fig. 14A and Fig. 14B, the guard film 21 is formed between the adjacent bit lines 7 to ensure insulation. Therefore, the memory cell region and its peripheral circuit region are silicided without short-circuit being caused between the adjacent bit lines 7 by the titanium silicides 15 and wiring resistance is suppressed. Thereby, higher-speed driving of the so-called SONOS-type flash memory can be realized.

### -Modification Example-

A modification example of the second embodiment will be explained here. A manufacturing method of an SONOS-type flash memory in this modification example is different from that in the second embodiment in that saliciding is performed. Note that the same reference numerals and symbols are used to designate the same components and so on as those explained in the second (first) embodiment, and therefore, the explanation thereof will be omitted.

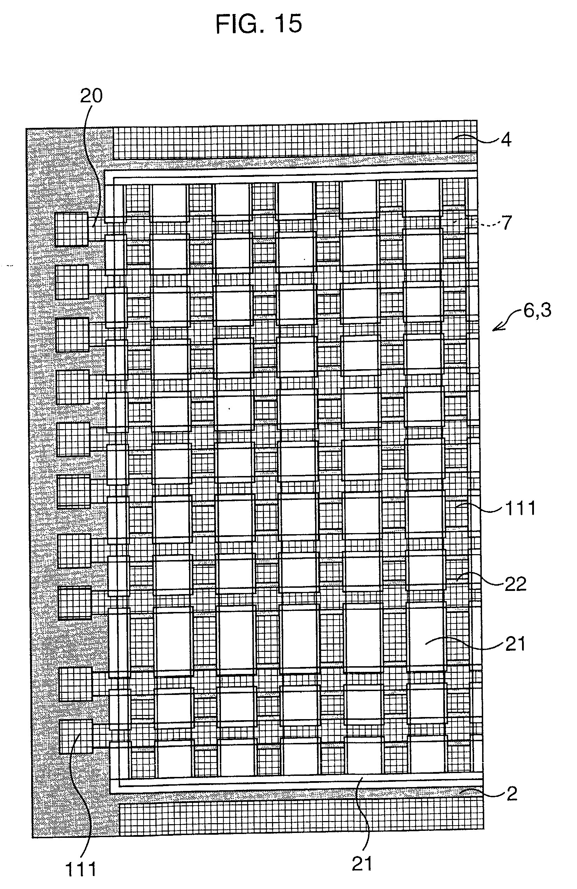

Fig.15 is a diagrammatic plan view showing a saliciding process in the modification example of the second embodiment.

After each process in Fig. 1 to Fig. 3 similarly to the above-described first embodiment, in the process corresponding to Fig. 4, a silicon nitride film is first formed by a plasma CVD method on the amorphous silicon, which is deposited at the time the word lines (and the gate electrodes in the active region 4) are formed. Thereby, the word lines 20 are formed without forming the metal silicide on the amorphous silicon.

Subsequently, after the same process as that in Fig. 12 in the second embodiment, the guard films 21 and the side walls 22 are formed as shown in Fig. 15. Thereafter, the silicon nitride film exposed on the word lines 20 in the active region 3 and on the gate electrodes in the active region 4 are removed by phosphoric acid boiling. Subsequently, the oxide film exposed on the bit lines 7 in the active region 3 and on the sources/drains in the active region 4 are removed by hydrofluoric acid treatment.

Subsequently, on the entire surface, cobalt (Co) is deposited until it has a film thickness of about 5 nm to about 10 nm, and TiN is deposited until it has a film thickness of about 20 nm to about 50 nm by a sputtering method. They are silicided by rapid anneal treatment (RTA) at a temperature of 450 °C to 550 °C. Thereby, the cobalt silicides 111 are formed on the surfaces of the bit lines 7 exposed between the guard films 21, the surfaces of the word lines 20 exposed from the guard film 21, and the surfaces of the sources/drains in the active region 4 of the peripheral circuit (only the active region 3 of the memory cell is shown here).

Thereafter, after the same processes as those in Fig. 13, Fig. 14A, and Fig. 14B, the SONOS-type flash memory is finished.

According to this modification example, in the active region 3 of the memory cell, insulation between the word lines 20 exposed from the guard film 21 and the cobalt silicides 111 is ensured by the side walls 22. Moreover, the guard film 21 is formed between the adjacent bit lines 7 to ensure insulation. Therefore, the memory cell region and its peripheral circuit region are silicided without short-circuit being caused between the adjacent bit lines 7 by the cobalt silicides 111 and wiring resistance is suppressed. Thereby, higher-speed driving of the so-called SONOS-type flash memory can be realized. In addition, a so-called dual gate is made possible through the use of the saliciding process, and a low-voltage operation can be realized by lowering a threshold (Vth).

### -Third Embodiment-

Next, a third embodiment of the present invention will be explained. A manufacturing method of an SONOS-type flash memory in this third embodiment is substantially the same as that in the first embodiment. However, it is different in the shape of the guard film at the time when the bit lines are silicided. Note that the same reference numerals and symbols are used to designate the same components and so on as those explained in the first embodiment, and therefore, the explanation thereof will be omitted.

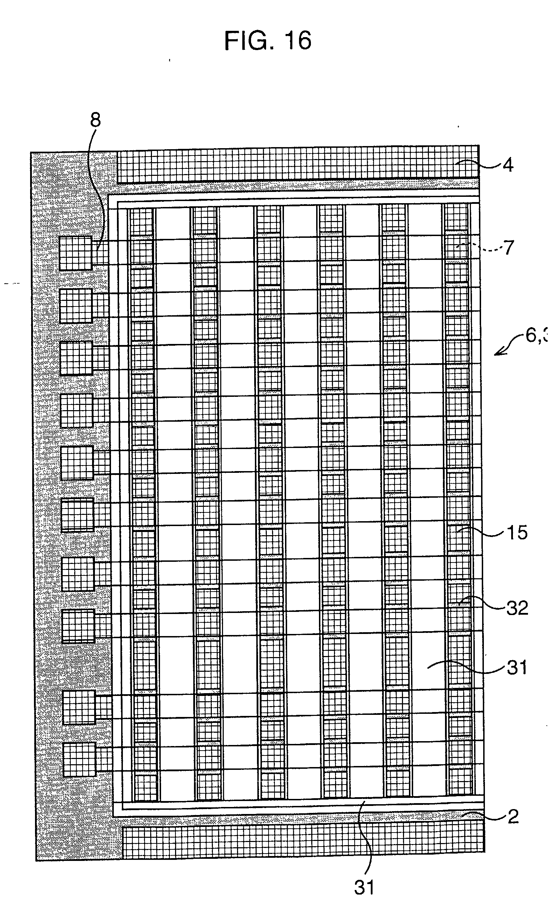

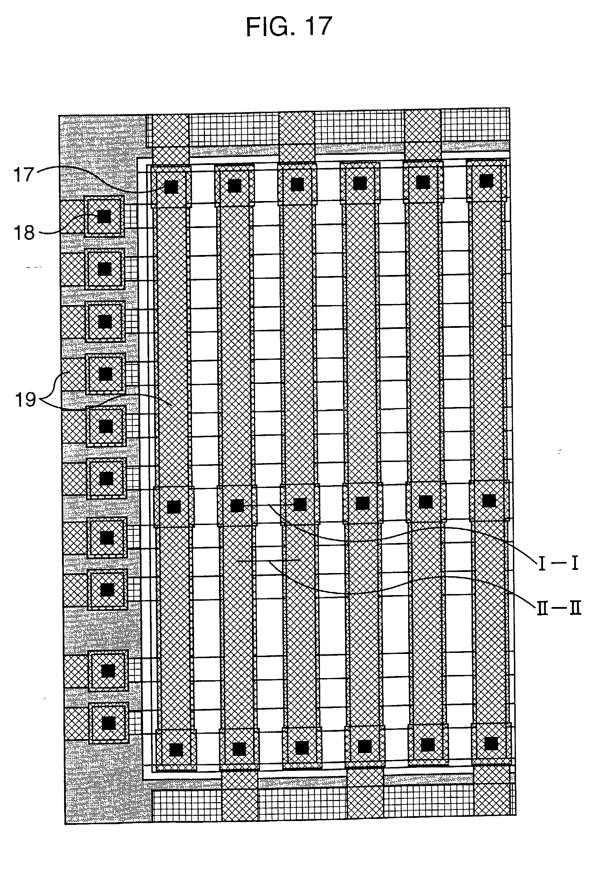

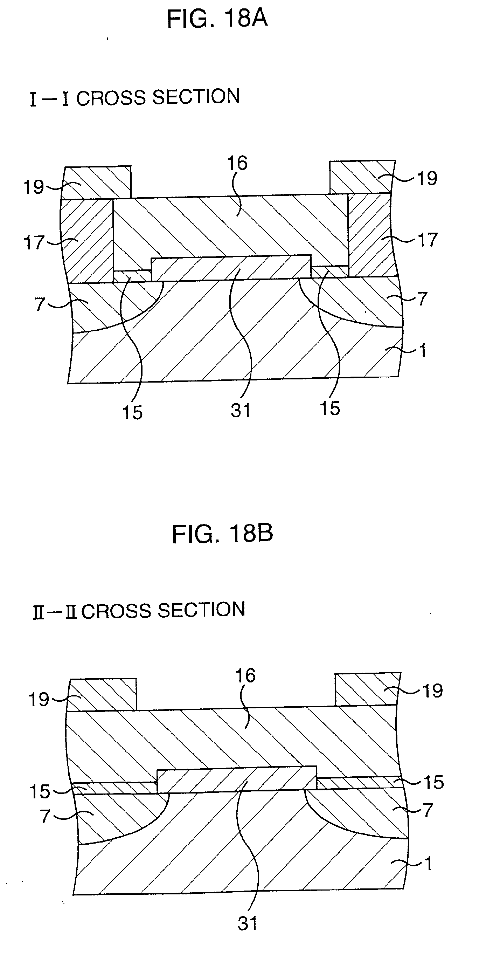

Fig. 16 and Fig. 17 are diagrammatic plan views showing major processes of the manufacturing method of the SONOS-type flash memory according to the third embodiment, and Fig. 18A and Fig. 18B are diagrammatic cross-sectional views of the same.

After each process in Fig. 1 to Fig. 3 similarly to the above-described first embodiment, a silicon oxide film is first deposited on the entire surface by a CVD method. Thereafter, as shown in Fig. 16, on this silicon oxide film, a latticed resist pattern (not shown) which is shaped to cover portions necessary for electrical insulation between the adjacent bit lines 7 and to leave metal silicide forming portions open is formed. In other words, here, this resist pattern is shaped to expose portions on the bit lines 7 in a longitudinal direction. Using this resist pattern as a mask, the silicon oxide film is full-anisotropically etched.

Then, ashing removal is performed for the resist pattern. Thereby, a guard film 31, which is composed of a plurality of belt-shaped silicon oxide films, covering the active region 3 with portions on the bit lines 7 exposed in the longitudinal direction is formed in the active region 3 of the memory cell. At the same time, side walls 32 are formed on side walls of the word lines 8 exposed from the guard film 31. In this way, insulation regions are constituted of the guard film 31 and the side walls 32. At this time, side walls (not shown) are also formed on the side walls of the gate electrodes in the active region 4 of the peripheral circuit.

Thereafter, titanium (Ti) is deposited on the entire surface by a sputtering method until it has a film thickness of about 20 nm to about 50 nm. Then, it is silicided by rapid anneal treatment (RTA) at a temperature of 650 °C to 750 °C. Thereby, the titanium silicides 15 are formed on the surfaces of the bit lines 7 exposed between the guard films 31 via the side walls 32 and on the surfaces of the sources/drains in the active region 4 of the peripheral circuit (only the active region 3 of the memory cell is shown here).

Subsequently, as shown in Fig. 17, Fig. 18A, and Fig. 18B (Fig. 18A shows a cross section taken along the line I-I in Fig. 17 and Fig. 18B shows a cross section taken along the line II-II in Fig. 17), after the interlayer insulation film 16 is formed on the entire surface by the CVD method, the contact holes 17, 18 are formed in the portions of the interlayer insulation film 16 which correspond to the connection hole forming regions.

Subsequently, oxide film removing processing by dry etching is performed for the exposed portions of the titanium silicides 15 in the active regions 3, 4 as pre-processing of a wiring forming process. Thereafter, a metal film made of an Al alloy or the like is formed by the sputtering method. By patterning of this metal film, the metal wiring 19 is formed, which is connected to the bit lines 7 and the word lines 8 (also to the gate electrodes, the sources/drains in the active region 4 of the peripheral circuit) via the contact holes 17, 18 and with which the bit lines 7 are backed.

Thereafter, after an interlayer insulation- film, contact holes (via holes), a wiring layer, and so on are further formed, the SONOS-type flash memory is finished.

According to this embodiment, in the active region 3 of the memory cell, insulation between the word lines 8 exposed from the guard film 31 and the titanium silicides 15 is ensured by the side walls 32. Moreover, as shown in Fig. 18A and Fig. 18B, the guard film 31 is formed between the adjacent bit lines 7 to ensure insulation. Therefore, the memory cell region and its peripheral circuit region are silicided without short-circuit being caused between the adjacent bit lines 7 by the titanium silicides 15 and wiring resistance is suppressed. Thereby, higher-speed driving of the so-called SONOS-type flash memory can be realized.

### -Modification Example-

A modification example of the third embodiment will be explained here. A manufacturing method of an SONOS-type flash memory in this modification example is different from that in the third embodiment in that saliciding is performed. Note that the same reference numerals and symbols are used to designate the same components and so on as those explained in the third (first) embodiment, and therefore, the explanation thereof will be omitted.

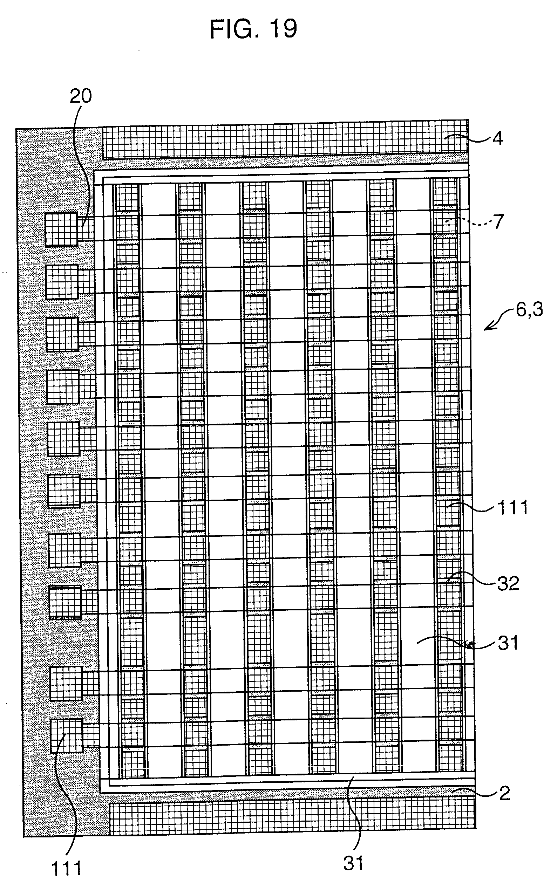

Fig.19 is a diagrammatic plan view showing a saliciding process in the modification example of the third embodiment.

After each process in Fig. 1 to Fig. 3 similarly to the above-described first embodiment, in the process corresponding to Fig. 4, a silicon nitride film is first formed by a plasma CVD method on the amorphous silicon, which is deposited at the time the word lines (and the gate electrodes in the active region 4) are formed. Thereby, the word lines 20 are formed without forming the metal silicide on the amorphous silicon.

Subsequently, after the same process as that in Fig. 16 in the third embodiment, the guard film 31 and the side walls 32 are formed as shown in Fig. 19. Thereafter, the silicon nitride film exposed on the word lines 20 in the active region 3 and on the gate electrodes in the active region 4 are removed by phosphoric acid boiling. Subsequently, the oxide film exposed on the bit lines 7 in the active region 3 and on the sources/drains in the active region 4 are removed by hydrofluoric acid treatment.

Subsequently, on the entire surface, cobalt (Co) is deposited until it has a film thickness of about 5 nm to about 10 nm, and TiN is deposited until it has a film thickness of about 20 nm to about 50 nm by a sputtering method. They are silicided by rapid anneal treatment (RTA) at a temperature of 450 °C to 550 °C. Thereby, the cobalt silicides 111 are formed on the surfaces of the bit lines 7 exposed between the guard films 31, the surfaces of the word lines 20 exposed from the guard film 31, and the surfaces of the sources/drains in the active region 4 of the peripheral circuit (only the active region 3 of the memory cell is shown here).

Thereafter, after the same processes as those in Fig. 13, Fig. 14A, and Fig. 14B, the SONOS-type flash memory is finished.

According to this modification example, in the active region 3 of the memory cell, insulation between the word lines 20 exposed from the guard film 31 and the cobalt silicides 111 is ensured by the side walls 32. Moreover, the guard film 31 is formed between the adjacent bit lines 7 to ensure insulation. Therefore, the memory cell region and its peripheral circuit region are salicided without short-circuit being caused between the adjacent bit lines 7 by the cobalt silicides 111 and wiring resistance is suppressed. Thereby, higher-speed driving of the so-called SONOS-type flash memory can be realized. In addition, a so-called dual gate is made possible through the use of the saliciding process, and a low-voltage operation can be realized by lowering a threshold (Vth).

### -Fourth Embodiment-

Next, a fourth embodiment of the present invention will be explained. A manufacturing method of an SONOS-type flash memory in this fourth embodiment is substantially the same as that in the first embodiment. However, it is different in that a salicided structure is employed and furthermore, different in insulation regions when the bit lines are silicided in the saliciding process. Note that the same reference numerals and symbols are used to designate the same components and so on as those explained in the first embodiment, and therefore, the explanation thereof will be omitted.

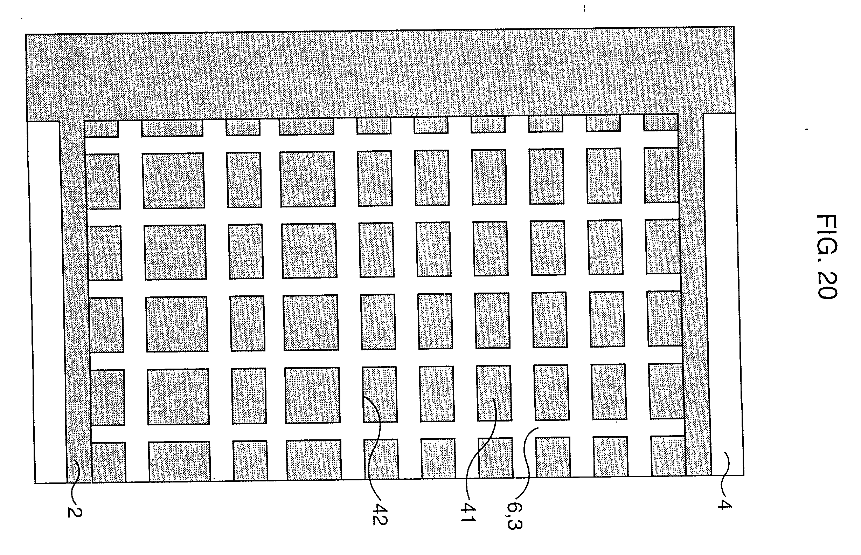

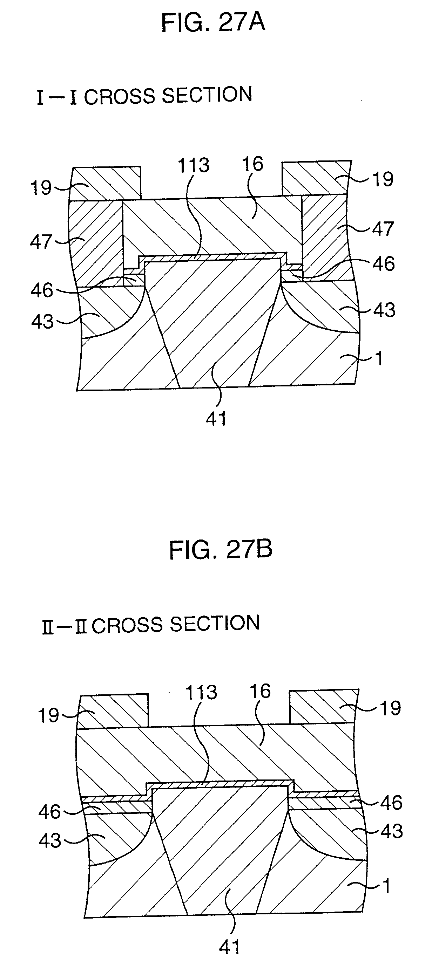

Fig. 20 to Fig. 26 are diagrammatic plan views showing major processes of the manufacturing method of the SONOS-type flash memory according to the fourth embodiment, and Fig. 27A and Fig. 27B are diagrammatic sectional views of the same.

In order to manufacture this flash memory, as shown in Fig. 20, the p-type silicon semiconductor substrate 1 is first prepared. On the surface of this semiconductor substrate 1, the field oxide film 2 with a film thickness of about 200 nm to about 500 nm are formed in an element separation region through thermal oxidation at a temperature of 900 °C to 1000 °C, for example, by a LOCOS method. Thereby, element separation is caused and the active region 3 of the memory cell and the active region 4 of the peripheral circuit where a CMOS transistor and so on are formed are demarcated.

In this case, instead of using the LOCOS method, a so-called STI element separating method, in which a trench (not shown) is formed in the element separation region of the semiconductor substrate 1 and an insulator is filled to the trench, may be used to demarcate the active regions.

Subsequently, for bit lines 43 and word lines 44 which are formed in later-described processes, a plurality of insulation portions 41 are formed in a matrix form in portions necessary for electrical insulation between the adjacent bit lines 43 in the active region 3. In other words, these insulation portions 41 are formed in areas surrounded by the bit lines 43 and the word lines 44 in a lattice form here. These insulation portions 41 constitute insulation regions.

Specifically, in the matrix portions surrounded by the bit lines 43 and the word lines 44 in a lattice form in the active region 3, trenches 42 which are about 0.2 µm to about 0.4 µm in depth are formed respectively by patterning. A silicon oxide film thick enough to fill these trenches 42 is deposited by a CVD method. Then, the surface is polished by a chemical mechanical polishing (CMP) method. Thereby, the insulation portions 41 which are formed by filling the respective trenches 42 with the silicon oxide film are formed. Incidentally, the insulation portions 41 may be formed as a field oxide film by the so-called LOCOS method.

Subsequently, the ONO film 6 which has a three-layered structure composed of the upper silicon oxide film, the silicon nitride film, and the lower silicon oxide film is formed on the semiconductor substrate 1.

More specifically, the lower silicon oxide film having a film thickness of about 5 nm to about 10 nm is first formed on the semiconductor substrate 1 by thermal oxidation at a temperature of 800 °C to 1100 °C. Next, the silicon nitride film having a film thickness of about 12 nm to about 16 nm is formed on the lower silicon oxide film by the CVD method at a temperature of 600 °C to 800 °C. Then, the upper silicon oxide film having a film thickness of about 5 nm to about 10 nm is formed on the silicon nitride film by wet oxidation at a temperature of 1000 °C to 1100 °C. These three layers constitute the ONO film 6. Incidentally, when the silicon nitride film is thinned, it is possible to form the upper silicon oxide film by the CVD method.

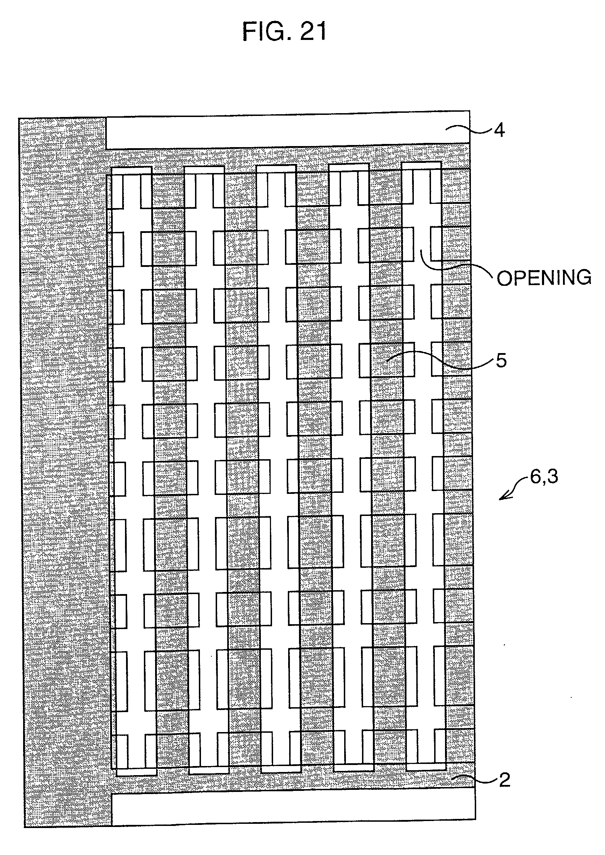

Subsequently, the entire surface is coated with a resist, and the resist pattern 5 having a plurality of belt-shaped openings is formed in the active region 3 of the memory cell by lithography, as shown in Fig. 21. Then, using this resist pattern 5 as a mask, an n-type impurity, arsenic (As) here, is ion-implanted under the condition of a dose amount of 1 x 10¹⁵ to 5 x 10¹⁵ (/cm²) and acceleration energy of 50 (keV) to 90 (keV). Thereby, the embedded bit lines 43 which become sources/drains are formed on the surface layer of the semiconductor substrate 1. At this time, arsenic is injected only to the substrate surface exposed from the belt-shaped openings in the active region 3, and is not injected to portions where the insulation portions 41 exposed from the openings exist.

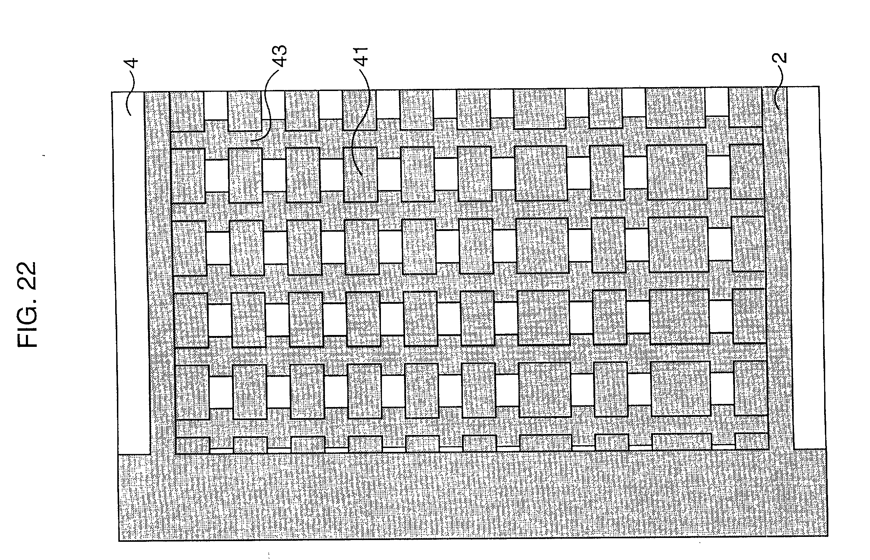

Next, as shown in Fig. 22, the resist pattern 5 is removed by ashing treatment or the like using oxygen plasma. At this time, the formed bit lines 43 are, for example, in a constricted centipede-like shape due to the existence of the insulation portions 41.

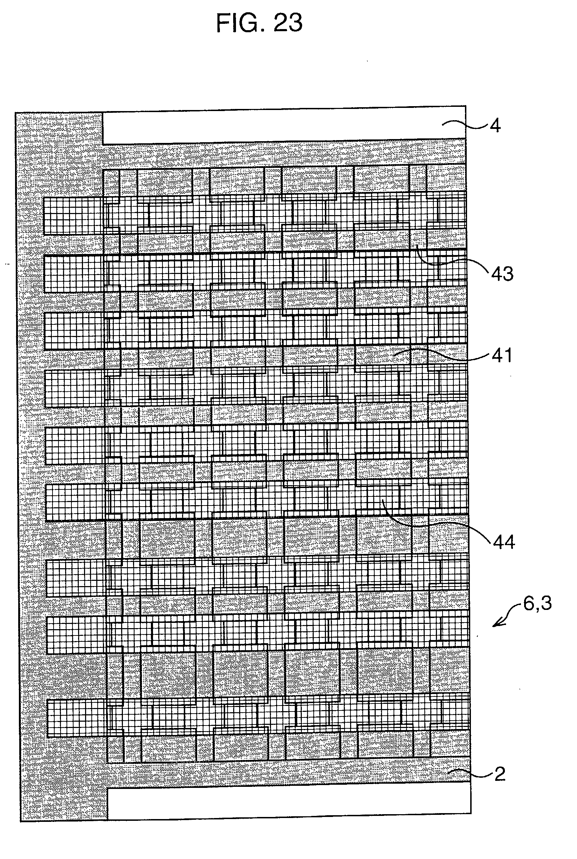

Subsequently, as shown in Fig. 23, the ONO film 6 in the active region 4 of the peripheral circuit is removed and the ONO film 6 is left only in the active region 3 of the memory cell. Thereafter, a gate insulation film (not shown) is formed in the active region 4 of the peripheral circuit.

Subsequently, amorphous silicon doped with phosphorus (P) whose concentration is 3 x 10²¹ (cm³) is deposited on the entire surface by the CVD method until it has a film thickness of about 100 nm to about 150 nm. A silicon nitride film is formed on this amorphous silicon by a plasma CVD method. Then, a resist pattern (not shown) in an electrode shape is formed. Using this resist pattern as a mask, the amorphous silicon is dry-etched using HCl/O₂ gas and the like as etching gas. In this way, the word lines 44 crossing (in this embodiment, crossing at right angles) the bit lines 43 via the ONO film 6 are formed in the active region 3 of the memory cell, and gate electrodes (not shown) are formed in the active region 4 of the peripheral circuit on the semiconductor substrate 1 via the gate insulation film.

Here, amorphous silicon doped with phosphorus is formed in the above example. However, it is possible to form a dual-gate structure by forming non-doped silicon instead and ion-implanting an n-type impurity and a p-type impurity separately using a resist pattern.

Subsequently, after ashing removal is performed for the resist pattern, a resist pattern (not shown) with only n-type transistor regions of the active region 4 of the peripheral circuit left open is formed. Using the gate electrodes as masks, an n-type impurity, arsenic here, is ion-implanted to the surface layer of the semiconductor substrate 1 under the condition of a dose amount of 1 x 10¹³ to 3 x 10¹³ (/cm²) and acceleration energy of 50 to 70 (keV) to form n-type LDDs. Next, a resist pattern (not shown), this time with only p-type transistor regions (n-type wells) of the active region 4 of the peripheral circuit left open is formed. Using the gate electrodes as masks, a p-type impurity, boron (B) here, is ion-implanted to the surface layer of the semiconductor substrate 1 under the condition of a dose amount of 3 x 10¹³ to 7 x 10¹³ (/cm²) and acceleration energy of 20 to 30 (keV) to form p-type LDDs.

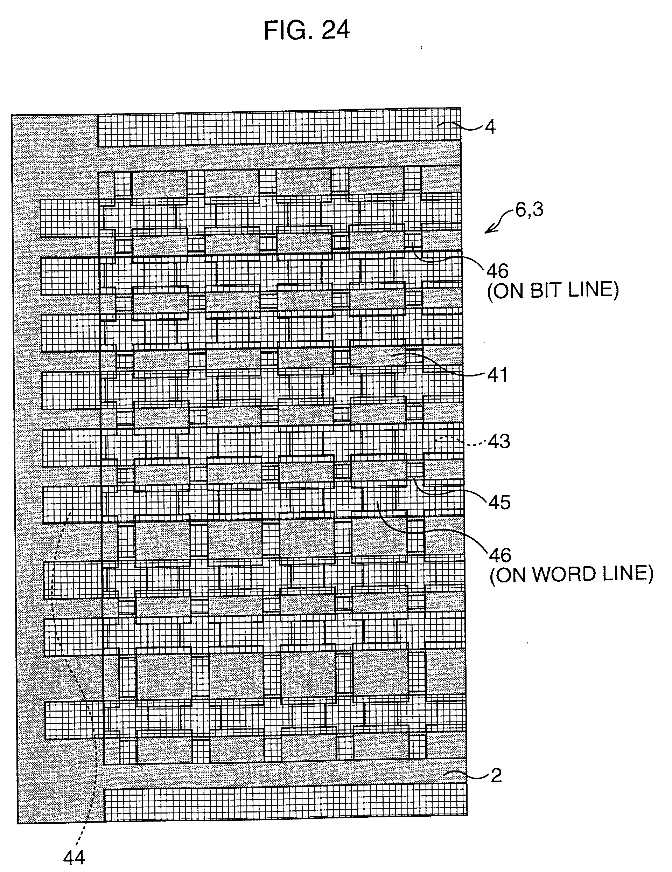

Subsequently, a silicon oxide film is deposited on the entire surface by the CVD method. This silicon oxide film is full-anisotropically etched. Thereby, as shown in Fig. 24, side walls 45 are formed on the side walls of the word lines 44 in the active region 3 of the memory cell. In the active region 4 of the peripheral circuit, side walls (not shown) are formed on the side walls of the gate electrodes. These side walls are for preventing short-circuit between the word lines 44 (gate electrodes) due to siliciding.

Subsequently, a resist pattern (not shown) with only n-type transistor regions of the active region 4 of the peripheral circuit left open is formed. Using the gate electrodes and the side walls as masks, an n-type impurity, arsenic here, is ion-implanted to the surface layer of the semiconductor substrate 1 under the condition of a dose amount of 3 x 10¹⁵ to 5 x 10¹⁵ (/cm²) and acceleration energy of 50 to 70 (keV) to form n-type sources/drains. Next, a resist pattern (not shown), this time with only p-type transistor regions (n-type wells) of the active region 4 of the peripheral circuit left open is formed. Using the gate electrodes and the side walls as masks, a p-type impurity, boron (B) here, is ion-implanted to the surface layer of the semiconductor substrate 1 under the condition of a dose amount of 3 x 10¹⁵ to 5 x 10¹⁵ (/cm²) and acceleration energy of 30 to 50 (keV) to form p-type sources/drains.

The silicon nitride film exposed on the word lines 44 in the active region 3 and on the gate electrodes in the active region 4 is removed by phosphoric acid boiling. Subsequently, the oxide film exposed on the bit lines 43 in the active region 3 and on the sources/drains in the active region 4 is removed by hydrofluoric acid treatment.

Subsequently, on the entire surface, cobalt (Co) is deposited until it has a film thickness of about 5 nm to about 10 nm, and TiN is deposited until it has a film thickness of about 20 nm to about 50 nm, by a sputtering method. They are silicided by rapid anneal treatment (RTA) at a temperature of 450 °C to 550 °C. Thereby, cobalt silicides 46 are formed on the surfaces of the bit lines 43, the surfaces of the word lines 44, and on the gate electrode and the surfaces of the sources/drains in the active region 4 of the peripheral circuit (only the active region 3 of the memory cell is shown here).

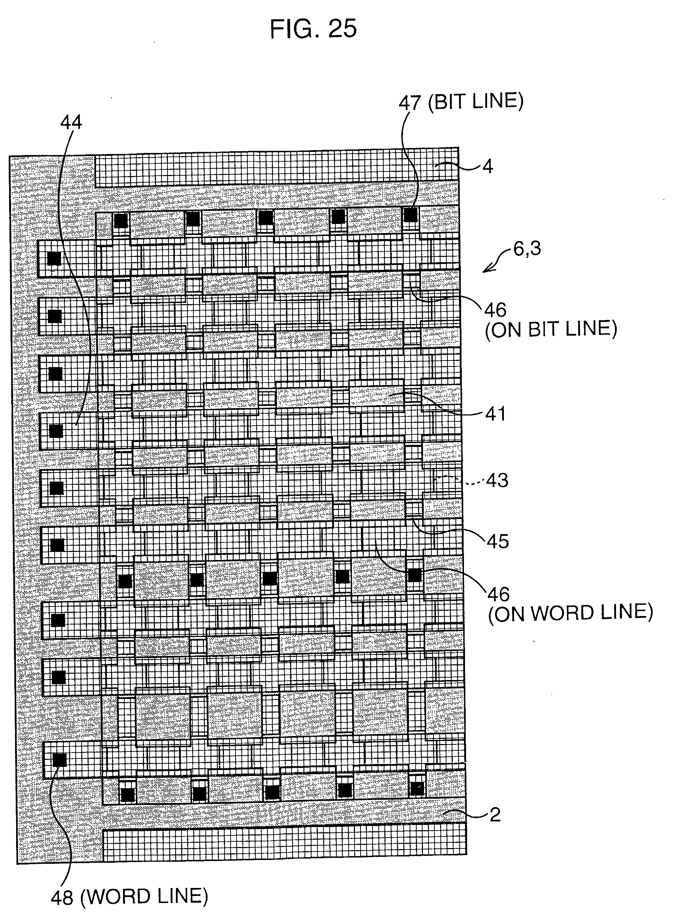

Subsequently, as shown in Fig. 25, the interlayer insulation film 16 is formed after a silicon nitride film 113 is formed on the entire surface by the CVD method in order to perform a process of forming so-called borderless contact holes. Thereafter, contact holes 47, 48 are formed in connection hole forming regions of the bit lines 43 and connection hole forming regions of the word lines 44 respectively.

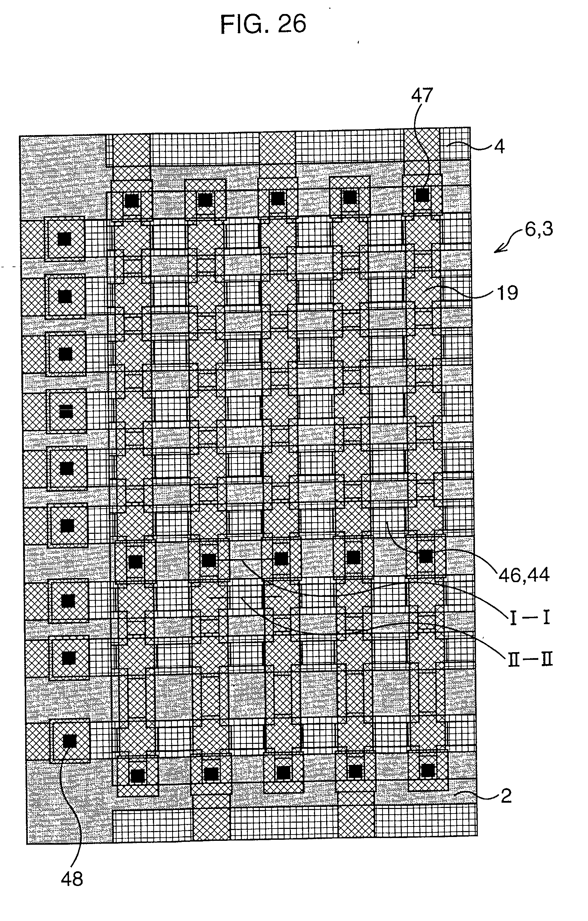

Subsequently, oxide film removing processing by dry etching is performed for the exposed portions of the cobalt silicides 46 in the active regions 3, 4 as pre-processing of a wiring forming process. Thereafter, as shown in Fig. 26, Fig. 27A, and Fig. 27B (Fig. 27A shows a cross section taken along the line I-I in Fig. 26 and Fig. 27B shows a cross section taken along the line II-II in Fig. 26), a metal film made of an Al alloy or the like is formed by the sputtering method and by patterning of this metal film, the metal wiring 19 is formed, which is connected to the bit lines 43 and the word lines 44 (also to the gate electrodes, the sources/drains in the active region 4 of the peripheral circuit) via the contact holes 47, 48 and with which the bit lines 43 are backed.

Thereafter, after an interlayer insulation film, contact holes (via holes), a wiring layer, and so on are further formed, the SONOS-type flash memory is finished.

According to this embodiment, in the active region 3 of the memory cell, insulation between the word lines 44 and the cobalt silicides 46 is ensured by the side walls 45. Moreover, as shown in Fig. 27A and Fig. 27B, the insulation portions 41 are formed between the adjacent bit lines 43 in advance to ensure insulation. Therefore, the memory cell region and its peripheral circuit region are salicided without short-circuit being caused between the adjacent bit lines 43 by the cobalt silicides 46 and wiring resistance is suppressed. Thereby, higher-speed driving of the so-called SONOS-type flash memory can be realized.

Moreover, the bit lines 43 can be directly aligned relative to the insulation portions 41. Therefore, there is no need to provide useless covers. Furthermore, a so-called dual gate is made possible by using the saliciding process and a low-voltage operation can also be realized by lowering a threshold (Vth).

### -Modification Examples-

Several modification examples of the fourth embodiment will be explained here. Manufacturing methods of an SONOS-type flash memory in these modification examples are different from that in the fourth embodiment in forms of disposition and so on of insulation regions. Note that the same reference numerals and symbols are used to designate the same components and so on as those explained in the fourth embodiment, and therefore, the explanation thereof will be omitted.

### -Modification Example 1-

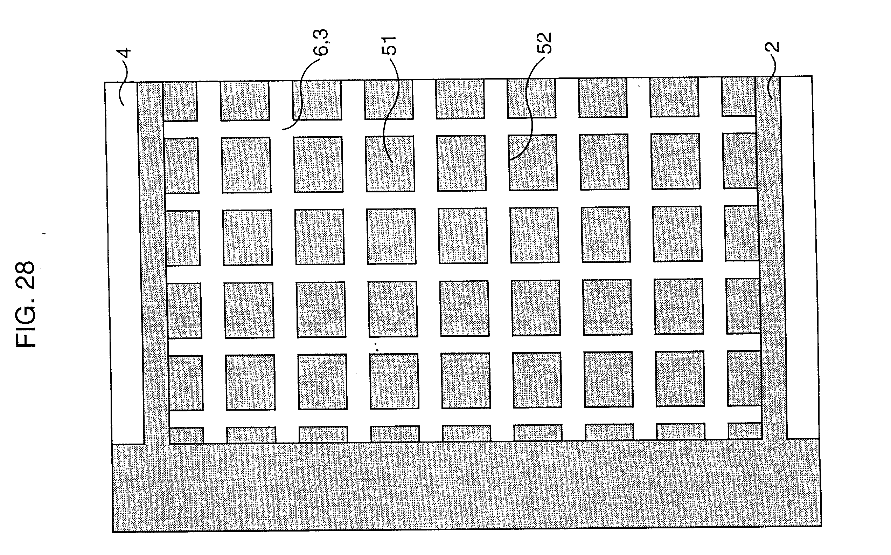

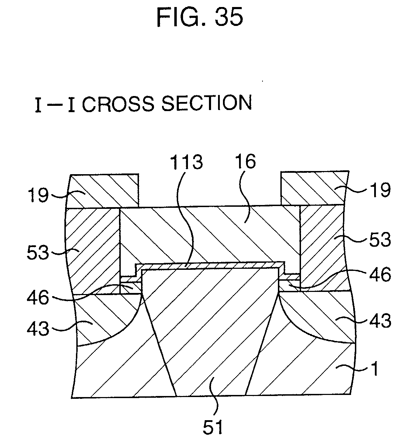

Fig. 28 to Fig. 34 are diagrammatic plan views showing major processes of a manufacturing method of an SONOS-type flash memory according to a modification example 1 of the fourth embodiment, and Fig. 35 is a diagrammatic sectional view of the same.

In order to manufacture this flash memory, the p-type silicon semiconductor substrate 1 is first prepared, as shown in Fig. 28. On the surface of this semiconductor substrate 1, the field oxide film 2 with a film thickness of about 200 nm to about 500 nm is formed in an element separation region through thermal oxidation at a temperature of 900 °C to 1000 °C, for example, by a LOCOS method. Thereby, element separation is caused and the active region 3 of the memory cell and the active region 4 of the peripheral circuit where a CMOS transistor and so on are formed are demarcated.

In this case, instead of using the LOCOS method, a so-called STI element separating method, in which a trench (not shown) is formed in the element separation region of the semiconductor substrate 1 and an insulator is filled to the trench, may be used to demarcate the active regions.

Subsequently, for the bit lines 43 and the word lines 44 which are formed in later-described processes, a plurality of insulation portions 51 are formed in a matrix-form in portions necessary for electrical insulation between the adjacent bit lines 43 in the active region 3. In other words, these insulation portions 51 are formed in areas surrounded by the bit lines 43 and the word lines 44 here.
These insulation portions 51 constitute insulation regions. Here, the disposition state of the insulation portions 51 in the insulation regions is a little more sparse than the disposition state of the insulation portions 41 in the insulation regions explained in the fourth embodiment.

Specifically, in the matrix portions surrounded by the bit lines 43 and the word lines 44 in a lattice form in the active region 3, trenches 52 which are about 0.2 µm to about 0.4 µm in depth are formed respectively by patterning. A silicon oxide film thick enough to fill these trenches 52 is deposited by a CVD method. Then, the surface is polished by a chemical mechanical polishing (CMP) method. Thereby, the insulation portions 51 which are formed by filling the respective trenches 52 with the silicon oxide film are formed. Incidentally, the insulation portions 51 may be formed as a field oxide film by the so-called LOCOS method.

Subsequently, the ONO film 6 which has a three-layered structure composed of the upper silicon oxide film, the silicon nitride film, and the lower silicon oxide film is formed on the semiconductor substrate 1.

More specifically, the lower silicon oxide film having a film thickness of about 5 nm to about 10 nm is first formed on the semiconductor substrate 1 by thermal oxidation at a temperature of 800 °C to 1100 °C. Next, the silicon nitride film having a film thickness of about 12 nm to about 16 nm is formed on the lower silicon oxide film by the CVD method at a temperature of 600 °C to 800 °C. Then, the upper silicon oxide film having a film thickness of about 5 nm to about 10 nm is formed on the silicon nitride film by wet oxidation at a temperature of 1000 °C to 1100 °C. These three layers constitute the ONO film 6. Incidentally, when the silicon nitride film is thinned, it is possible to form the upper silicon oxide film by the CVD method.

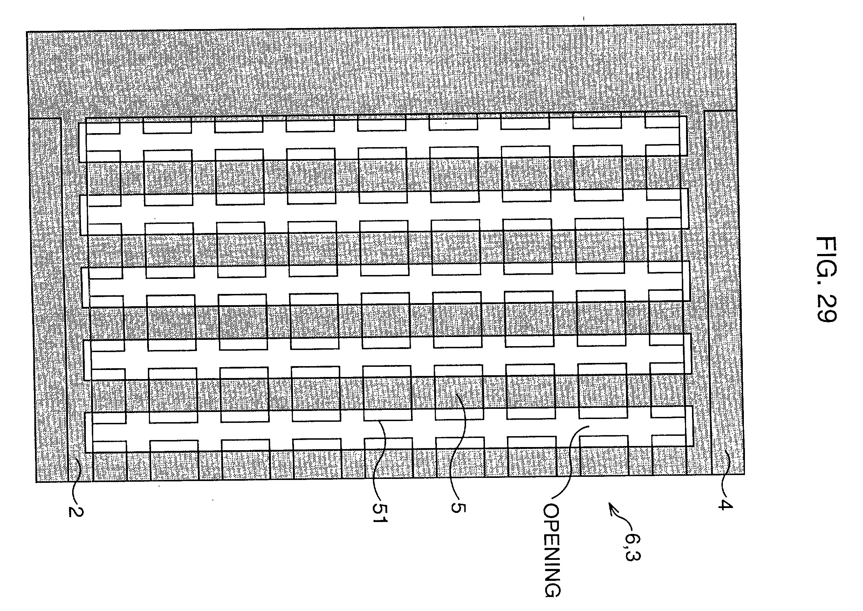

Subsequently, as shown in Fig. 29, the entire surface is coated with a resist, and the resist pattern 5 having a plurality of belt-shaped openings is formed in the active region 3 of the memory cell by lithography. Then, using this resist pattern 5 as a mask, an n-type impurity, arsenic (As) here, is ion-implanted under the condition of a dose amount of 1 x 10¹⁵ to 5 x 10¹⁵ (/cm²) and acceleration energy of 50 (keV) to 90 (keV). Thereby, the embedded bit lines 43 which become sources/drains are formed on the surface layer of the semiconductor substrate 1. At this time, arsenic is injected only to the substrate surface exposed from the belt-shaped openings in the active region 3, and is not injected to portions where the insulation portions 51 exposed from the openings exist.

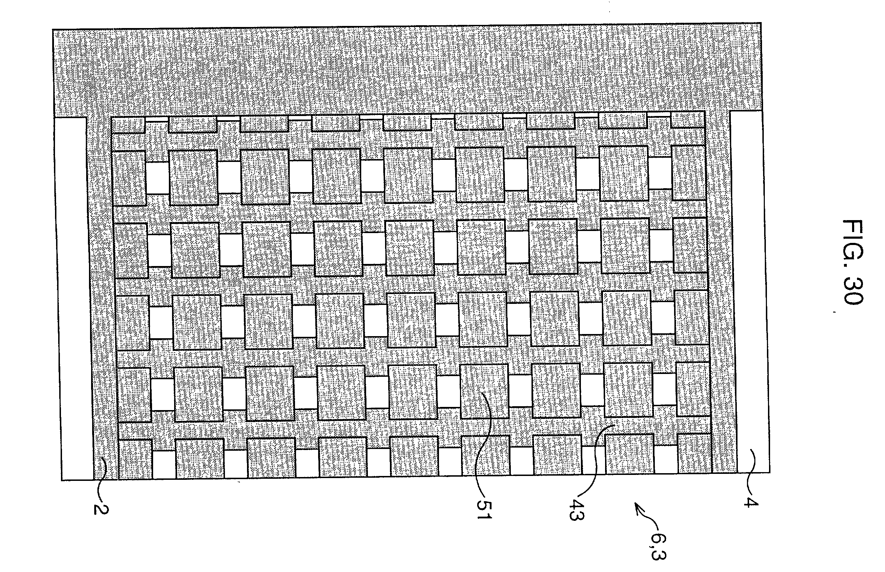

Next, the resist pattern 5 is removed by ashing treatment or the like using oxygen plasma, as shown in Fig. 30. At this time, the formed bit lines 43 are, for example, in a constricted centipede-like shape due to the existence of the insulation portions 51.

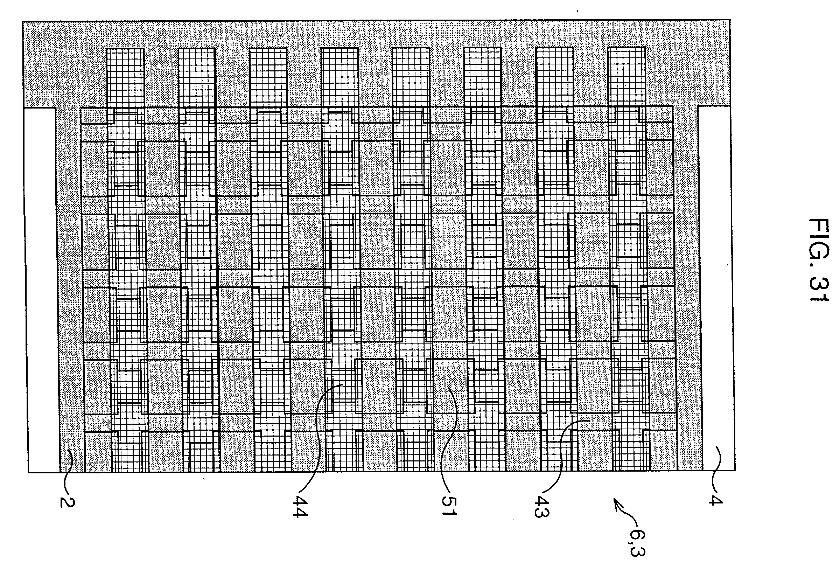

Subsequently, as shown in Fig. 31, after the ONO film 6 in the active region 4 of the peripheral circuit is removed and the ONO film 6 is left only in the active region 3 of the memory cell, a gate insulation film (not shown) is formed in the active region 4 of the peripheral circuit.

Subsequently, amorphous silicon doped with phosphorus (P) whose concentration is 3 x 10²¹ (cm³) is deposited on the entire surface by the CVD method until it has a film thickness of about 100 nm to about 150 nm. A silicon nitride film is formed on this amorphous silicon by a plasma CVD method. Then, a resist pattern (not shown) in an electrode shape is formed. Using this resist pattern as a mask, the amorphous silicon is dry-etched using HCl/O₂ gas and the like as etching gas. In this way, the word lines 44 crossing (in this example, crossing at right angles) the bit lines 43 via the ONO film 6 are formed in the active region 3 of the memory cell, and gate electrodes (not shown) are formed in the active region 4 of the peripheral circuit on the semiconductor substrate 1 via the gate insulation film.

Here, amorphous silicon doped with phosphorus is formed in the above example. However, it is possible to form a dual-gate structure by forming non-doped silicon instead and ion-implanting an n-type impurity and a p-type impurity separately using a resist pattern.

Subsequently, ashing removal is performed for the resist pattern. Thereafter, a resist pattern (not shown) with only n-type transistor regions of the active region 4 of the peripheral circuit left open is formed. Using the gate electrodes as masks, an n-type impurity, arsenic here, is ion-implanted to the surface layer of the semiconductor substrate 1 under the condition of a dose amount of 1 x 10¹³ to 3 x 10¹³ (/cm²) and acceleration energy of 50 to 70 (keV) to form n-type LDDs. Next, a resist pattern (not shown), this time with only p-type transistor regions (n-type wells) of the active region 4 of the peripheral circuit left open is formed. Using the gate electrodes as masks, a p-type impurity, boron (B) here, is ion-implanted to the surface layer of the semiconductor substrate 1 under the condition of a dose amount of 3 x 10¹³ to 7 x 10¹³ (/cm²) and acceleration energy of 20 to 30 (keV) to form p-type LDDs.

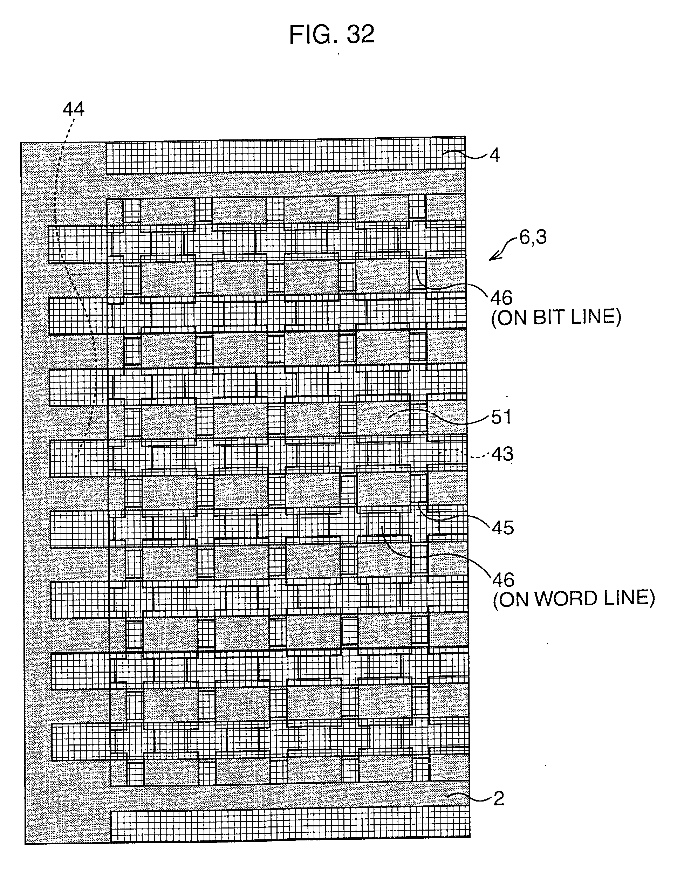

Subsequently, a silicon oxide film is deposited on the entire surface by the CVD method. This silicon oxide film is full-anisotropically etched. Thereby, as shown in Fig. 32, the side walls 45 are formed on the side walls of the word lines 44 in the active region 3 of the memory cell. In the active region 4 of the peripheral circuit, side walls (not shown) are formed on the side walls of the gate electrodes. These side walls are for preventing short-circuit between the word lines 44 (gate electrodes) due to siliciding.

Subsequently, a resist pattern (not shown) with only n-type transistor regions of the active region 4 of the peripheral circuit left open is formed. Using the gate electrodes and the side walls as masks, an n-type impurity, arsenic here, is ion-implanted to the surface layer of the semiconductor substrate 1 under the condition of a dose amount of 3 x 10¹⁵ to 5 x 10¹⁵ (/cm²) and acceleration energy of 50 to 70 (keV) to form n-type sources/drains. Next, a resist pattern (not shown), this time with only p-type transistor regions (n-type wells) of the active region 4 of the peripheral circuit left open is formed. Using the gate electrodes and the side walls as masks, a p-type impurity, boron (B) here, is ion-implanted to the surface layer of the semiconductor substrate 1 under the condition of a dose amount of 3 x 10¹⁵ to 5 x 10¹⁵ (/cm²) and acceleration energy of 30 to 50 (keV) to form p-type sources/drains.

The silicon nitride film exposed on the word lines 44 in the active region 3 and on the gate electrodes in the active region 4 is removed by phosphoric acid boiling. Subsequently, the oxide film exposed on the bit lines 43 in the active region 3 and on the sources/drains in the active region 4 is removed by hydrofluoric acid treatment.

Subsequently, on the entire surface, cobalt (Co) is deposited until it has a film thickness of about 5 nm to about 10 nm, and TiN is deposited until it has a film thickness of about 20 nm to about 50 nm by a sputtering method. They are silicided by rapid anneal treatment (RTA) at a temperature of 450 °C to 550 °C. Thereby, the cobalt silicides 46 are formed on the surfaces of the bit lines 43, the surfaces of the word lines 44, and on the gate electrodes and the surfaces of the sources/drains in the active region 4 of the peripheral circuit (only the active region 3 of the memory cell is shown here).

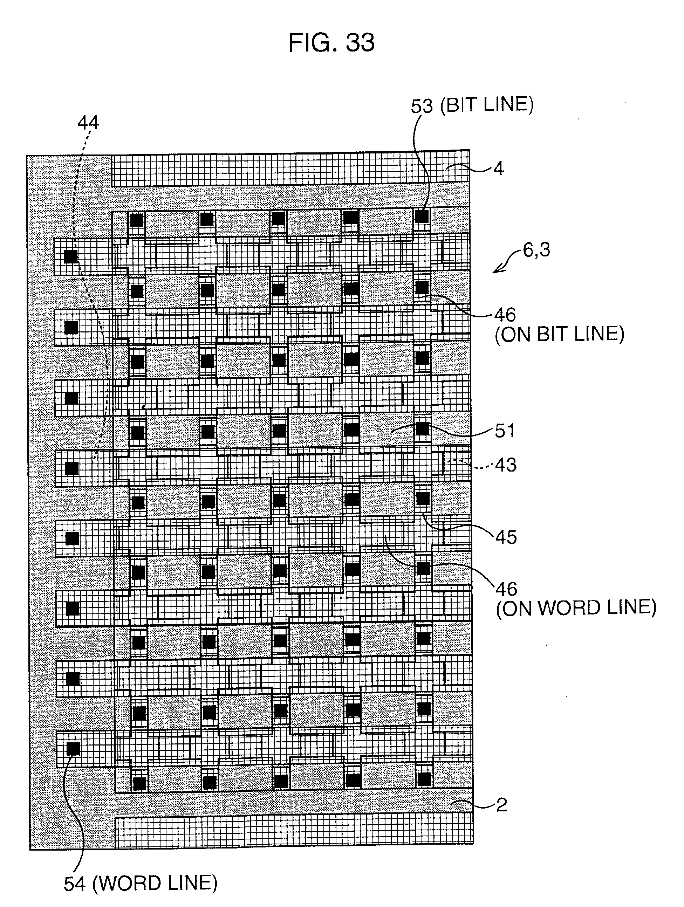

Subsequently, as shown in Fig.33, the interlayer insulation film 16 is formed after the silicon nitride film 113 is formed on the entire surface by the CVD method in order to perform a process of forming so-called borderless contact holes. Thereafter, contact holes 53, 54 are formed in connection hole forming regions of the bit lines 43 and connection hole forming regions of the word lines 44 respectively. Here, the contact holes 53 of the bit lines 43 are formed a little more densely than the contact holes 47, 48 explained in the fourth embodiment.

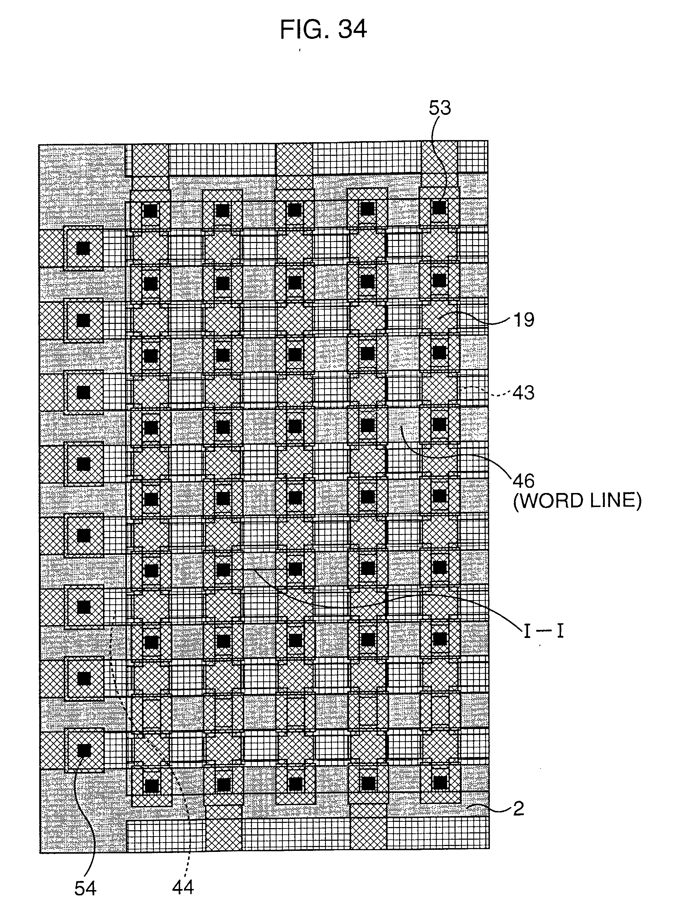

Subsequently, as shown in Fig. 34 and Fig. 35 (a cross section taken along the line I-I in Fig. 34), after oxide film removing processing by dry etching is performed for the exposed portions of the cobalt silicides 46 in the active regions 3, 4 as pre-processing of a wiring forming process, a metal film made of an Al alloy or the like is formed by the sputtering method, and by patterning of this metal film, the metal wiring 19 is formed, which is connected to the bit lines 43 and the word lines 44 (also to the gate electrodes, the sources/drains in the active region 4 of the peripheral circuit) via the contact holes 53, 54 and with which the bit lines 43 are backed.

Thereafter, after an interlayer insulation film, contact holes (via holes), a wiring layer, and so on are further formed, the SONOS-type flash memory is finished.

According to this modification example 1, in the active region 3 of the memory cell, insulation between the word lines 44 and the cobalt silicides 46 is ensured by the side walls 14. Moreover, as shown in Fig. 35, the insulation portions 51 are formed between the adjacent bit lines 43 in advance to ensure insulation. Therefore, the memory cell region and its peripheral circuit region are salicided without short-circuit being caused between the adjacent bit lines 43 by the cobalt silicides 46 and wiring resistance is suppressed. Thereby, higher-speed driving of the so-called SONOS-type flash memory can be realized.

Moreover, the bit lines 43 can be directly aligned relative to the insulation portions 51. Therefore, there is no need to provide useless covers. Furthermore, a so-called dual gate is made possible by using the saliciding process and a low-voltage operation can also be realized by lowering a threshold (Vth).

### -Modification Example 2-

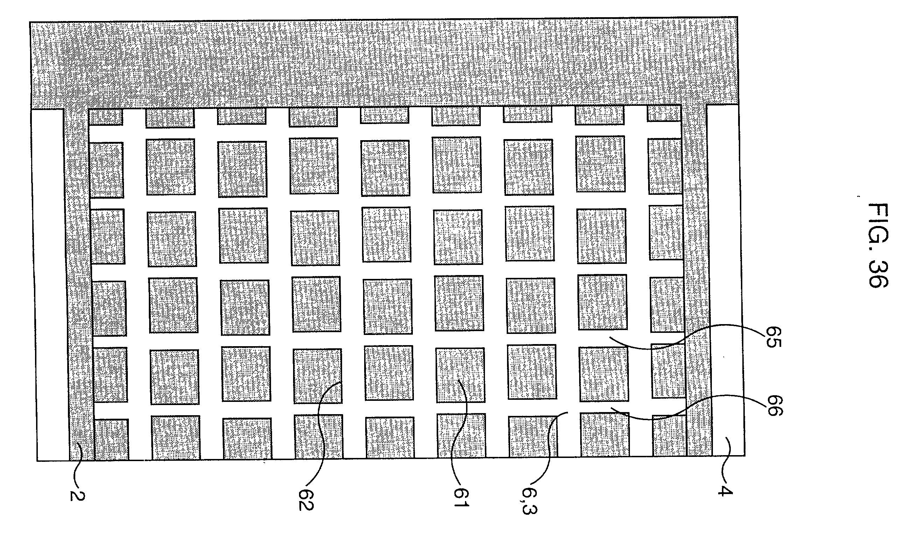

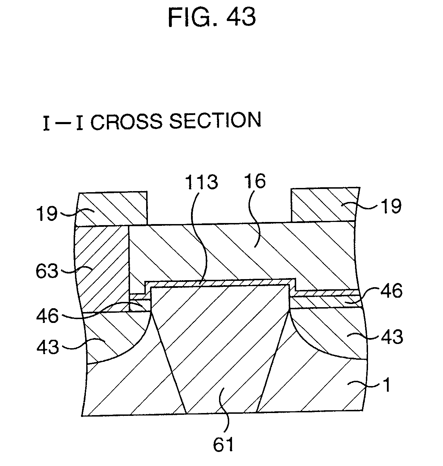

Fig. 36 to Fig. 42 are diagrammatic plan views showing major processes of a manufacturing method of an SONOS-type flash memory according to a modification example 2 of the fourth embodiment, and Fig. 43 is a diagrammatic sectional view of the same.

In order to manufacture this flash memory, the p-type silicon semiconductor substrate 1 is first prepared, as shown in Fig. 36. On the surface of this semiconductor substrate 1, the field oxide film 2 with a film thickness of about 200 nm to about 500 nm is formed in an element separation region through thermal oxidation at a temperature of 900 °C to 1000 °C, for example, by a LOCOS method. Thereby, element separation is caused and the active region 3 of the memory cell and the active region 4 of the peripheral circuit where a CMOS transistor and so on are formed are demarcated.

In this case, instead of using the LOCOS method, a so-called STI element separating method, in which a trench (not shown) is formed in the element separation region of the semiconductor substrate 1 and an insulator is filled to the trench, may be used to demarcate the active regions.

Subsequently, for the bit lines 43 and the word lines 44 which are formed in later-described processes, a plurality of insulation portions 61 are formed in a matrix-form in portions necessary for electrical insulation between the adjacent bit lines 43 in the active region 3. In other words, these insulation portions 61 are formed in areas surrounded by the bit lines 43 and the word lines 44 in a lattice form here. These insulation portions 61 constitute insulation regions. Here, the disposition state of the insulation portions 61 in the corresponding insulation regions is a little different from the disposition state of the insulation portions 51 in the insulation regions explained in the modification example 1 of the fourth embodiment. It is not necessary to secure the size of the contact holes in contact hole non-forming regions 66 of the bit lines 43. Taking this into consideration, the contact hole non-forming regions 66 are formed to be narrower in width than the contact hole forming regions 65 of the bit lines 43.

Specifically, in the matrix portions surrounded by the bit lines 43 and the word lines 44 in a lattice form in the active region 3, trenches 62 which are about 0.2 µm to about 0.4 µm in depth are formed respectively by patterning. A silicon oxide film thick enough to fill these trenches 62 is deposited by a CVD method. Then, the surface is polished by a chemical mechanical polishing (CMP) method. Thereby, the insulation portions 61 which are formed by filling the respective trenches 62 with the silicon oxide film are formed. Incidentally, the insulation portions 61 may be formed as a field oxide film by the so-called LOCOS method.

Subsequently, the ONO film 6 which has a three-layered structure composed of the upper silicon oxide film, the silicon nitride film, and the lower silicon oxide film is formed on the semiconductor substrate 1.

More specifically, the lower silicon oxide film having a film thickness of about 5 nm to about 10 nm is first formed on the semiconductor substrate 1 by thermal oxidation at a temperature of 800 °C to 1100 °C. Next, the silicon nitride film having a film thickness of about 12 nm to about 16 nm is formed on the lower silicon oxide film by the CVD method at a temperature of 600 °C to 800 °C. Then, the upper silicon oxide film having a film thickness of about 5 nm to about 10 nm is formed on the silicon nitride film by wet oxidation at a temperature of 1000 °C to 1100 °C. These three layers constitute the ONO film 6. Incidentally, when the silicon nitride film is thinned, it is possible to form the upper silicon oxide film by the CVD method.

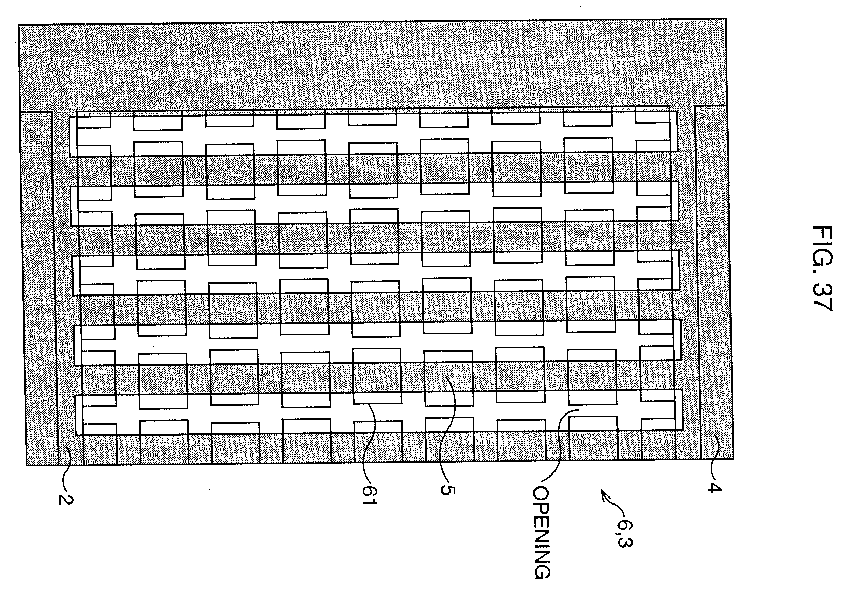

Subsequently, as shown in Fig. 37, the entire surface is coated with a resist to form the resist pattern 5 having a plurality of belt-shaped openings in the active region 3 of the memory cell by lithography. Then, using this resist pattern 5 as a mask, an n-type impurity, arsenic (As) here, is ion-implanted under the condition of a dose amount of 1 x 10¹⁵ to 5 x 10¹⁵ (/cm²) and acceleration energy of 50 (keV) to 90 (keV). Thereby, the embedded bit lines 43 which become sources/drains are formed on the surface layer of the semiconductor substrate 1. At this time, arsenic is injected only to the substrate surface exposed from the belt-shaped openings in the active region 3, and is not injected to portions where the insulation portions 61 exposed from the openings exist.

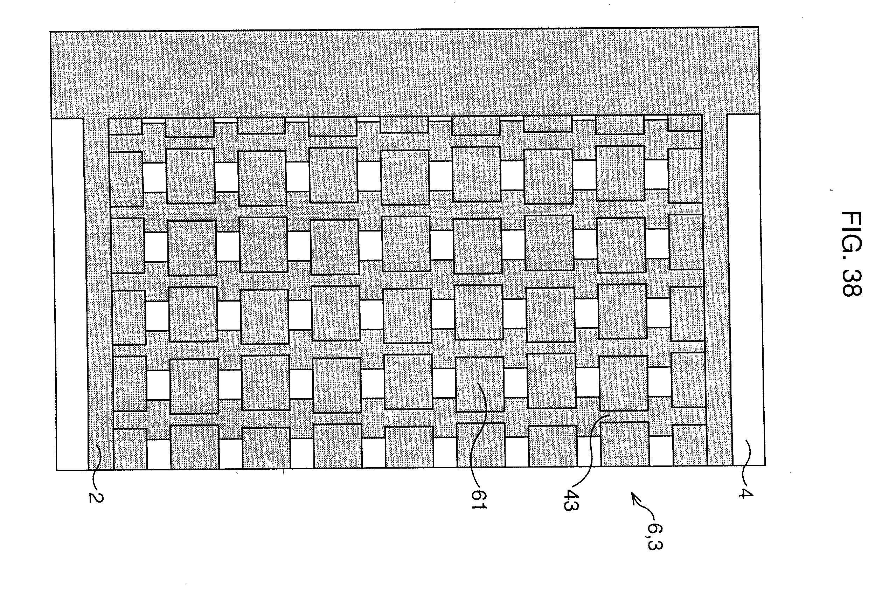

Next, the resist pattern 5 is removed by ashing treatment or the like using oxygen plasma, as shown in Fig. 38. At this time, the formed bit lines 43 are, for example, in a constricted centipede-like shape due to the existence of the insulation portions 51.

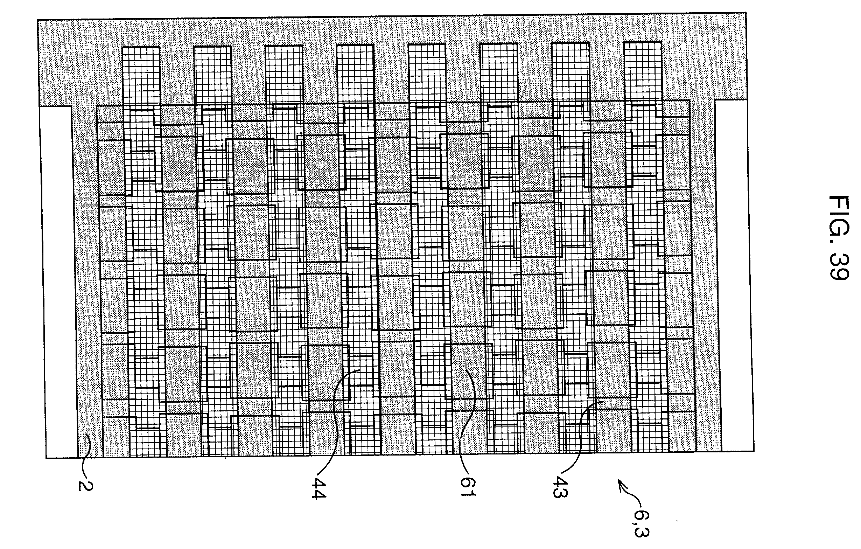

Subsequently, as shown in Fig. 39, after the ONO film 6 in the active region 4 of the peripheral circuit is removed and the ONO film 6 is left only in the active region 3 of the memory cell, a gate insulation film (not shown) is formed in the active region 4 of the peripheral circuit.

Subsequently, amorphous silicon doped with phosphorus (P) whose concentration is 3 x 10²¹ (cm³) is deposited on the entire surface by the CVD method until it has a film thickness of about 100 nm to about 150 nm. A silicon nitride film is formed on this amorphous silicon by a plasma CVD method. Then, a resist pattern (not shown) in an electrode shape is formed. Using this resist pattern as a mask, the amorphous silicon is dry-etched using HCl/O₂ gas and the like as etching gas. In this way, the word lines 44 crossing (in this example, crossing at right angles) the bit lines 43 via the ONO film 6 is formed in the active region 3 of the memory cell, and gate electrodes (not shown) are formed in the active region 4 of the peripheral circuit on the semiconductor substrate 1 via the gate insulation film.

Here, amorphous silicon doped with phosphorus is formed in the above example. However, it is possible to form a dual-gate structure by forming non-doped silicon instead and ion-implanting an n-type impurity and a p-type impurity separately using a resist pattern.

Subsequently, ashing removal is performed for the resist pattern. Thereafter, a resist pattern (not shown) with only n-type transistor regions of the active region 4 of the peripheral circuit left open is formed. Using the gate electrodes as masks, an n-type impurity, arsenic here, is ion-implanted to the surface layer of the semiconductor substrate 1 under the condition of a dose amount of 1 x 10¹³ to 3 x 10¹³ (/cm²) and acceleration energy of 50 to 70 (keV) to form n-type LDDs. Next, a resist pattern (not shown), this time with only p-type transistor regions (n-type wells) of the active region 4 of the peripheral circuit left open is formed. Using the gate electrodes as masks, a p-type impurity, boron (B) here, is ion-implanted to the surface layer of the semiconductor substrate 1 under the condition of a dose amount of 3 x 10¹³ to 7 x 10¹³ (/cm²) and acceleration energy of 20 to 30 (keV) to form p-type LDDs.

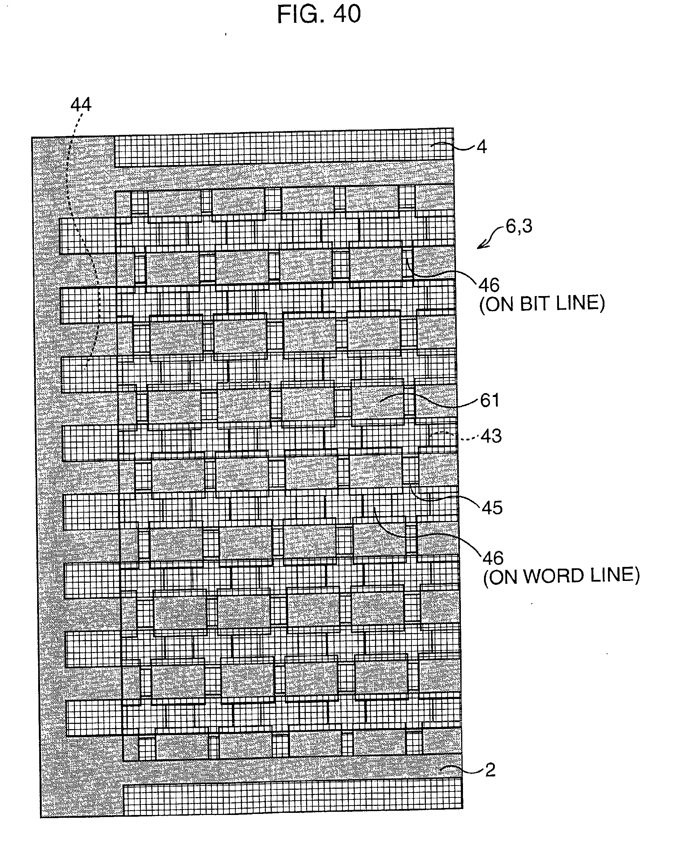

Subsequently, a silicon oxide film is deposited on the entire surface by the CVD method. This silicon oxide film is full-anisotropically etched. Thereby, as shown in Fig. 40, the side walls 45 are formed on the side walls of the word lines 44 in the active region 3 of the memory cell. In the active region 4 of the peripheral circuit, side walls (not shown) are formed on the side walls of the gate electrodes. These side walls are for preventing short-circuit between the word lines 44 (gate electrodes) due to siliciding.

Subsequently, a resist pattern (not shown) with only n-type transistor regions of the active region 4 of the peripheral circuit left open is formed. Using the gate electrodes and the side walls as masks, an n-type impurity, arsenic here, is ion-implanted to the surface layer of the semiconductor substrate 1 under the condition of a dose amount of 3 x 10¹⁵ to 5 x 10¹⁵ (/cm²) and acceleration energy of 50 to 70 (keV) to form n-type sources/drains. Next, a resist pattern (not shown), this time with only p-type transistor regions (n-type wells) of the active region 4 of the peripheral circuit left open is formed. Using the gate electrodes and the side walls as masks, a p-type impurity, boron (B) here, is ion-implanted to the surface layer of the semiconductor substrate 1 under the condition of a dose amount of 3 x 10¹⁵ to 5 x 10¹⁵ (/cm²) and acceleration energy of 30 to 50 (keV) to form p-type sources/drains.

The silicon nitride film exposed on the word lines 44 in the active region 3 and on the gate electrodes in the active region 4 is removed by phosphoric acid boiling. Subsequently, the oxide film exposed on the bit lines 43 in the active region 3 and on the sources/drains in the active region 4 is removed by hydrofluoric acid treatment.

Subsequently, on the entire surface, cobalt (Co) is deposited until it has a film thickness of about 5 nm to about 10 nm, and TiN is deposited until it has a film thickness of about 20 nm to about 50 nm by a sputtering method. They are silicided by rapid anneal treatment (RTA) at a temperature of 450 °C to 550 °C. Thereby, the cobalt silicides 46 are formed on the surfaces of the bit lines 43, the surfaces of the word lines 44, and on the gate electrodes and the surfaces of the sources/drains in the active region 4 of the peripheral circuit (only the active region 3 of the memory cell is shown here).

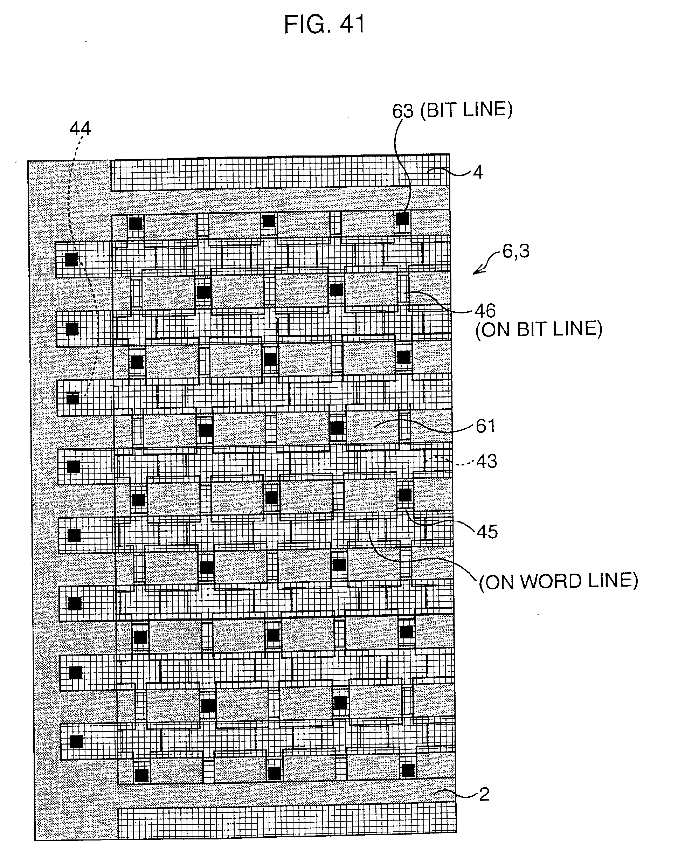

Subsequently, as shown in Fig.41, the interlayer insulation film 16 is formed after the silicon nitride film 113 is formed on the entire surface by the CVD method in order to perform a process of forming so-called borderless contact holes. Thereafter, contact holes 63, 64 are formed in connection hole forming regions 65 of the bit lines 43 and connection hole forming regions of the word lines 44 respectively.

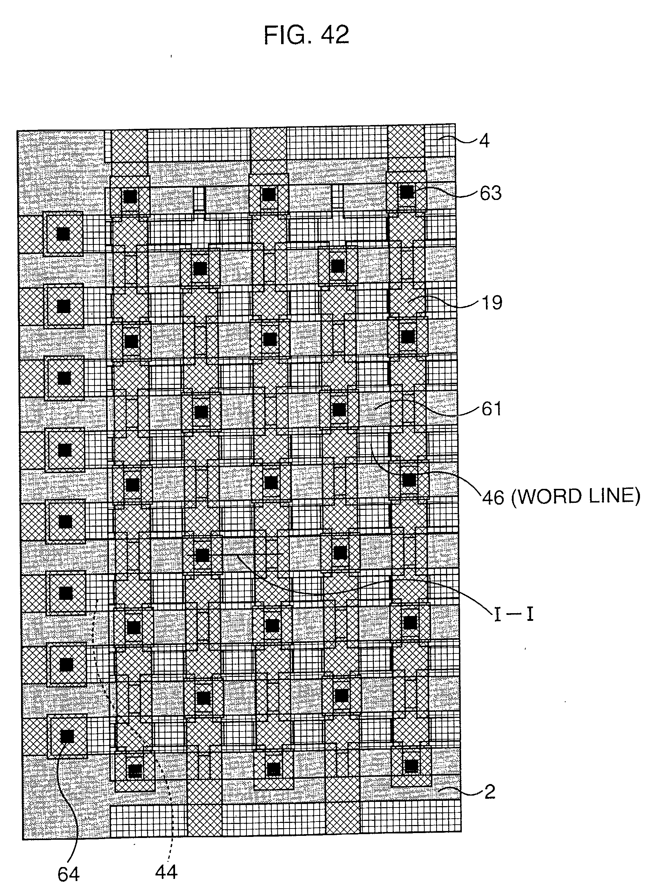

Subsequently, as shown in Fig. 42 and Fig. 43 (a cross section taken along the line I-I in Fig. 42), after oxide film removing processing by dry etching is performed for the exposed portions of the cobalt silicides 46 in the active regions 3, 4 as pre-processing of a wiring forming process, a metal film made of an Al alloy or the like is formed by the sputtering method, and by patterning of this metal film, the metal wiring 19 is formed, which is connected to the bit lines 43 and the word lines 44 (also to the gate electrodes, the sources/drains in the active region 4 of the peripheral circuit) via the contact holes 63, 64 and with which the bit lines 43 are backed.

Thereafter, after an interlayer insulation film, contact holes (via holes), a wiring layer, and so on are further formed, the SONOS-type flash memory is finished.

According to this modification example 2, in the active region 3 of the memory cell, insulation between the word lines 44 and the cobalt silicides 46 is ensured by the side walls 45. Moreover, as shown in Fig. 43, the insulation portions 61 are formed between the adjacent bit lines 43 in advance to ensure insulation. Therefore, the memory cell region and its peripheral circuit region are salicided without short-circuit being caused between the adjacent bit lines 43 by the cobalt silicides 46 and wiring resistance is suppressed. Thereby, higher-speed driving of the so-called SONOS-type flash memory can be realized.

Moreover, the bit lines 43 can be directly aligned relative to the insulation portions 61. Therefore, there is no need to provide useless covers. Furthermore, a so-called dual gate is made possible by using the saliciding process and a low-voltage operation can also be realized by lowering a threshold (Vth).

### -Modification Example 3-

A manufacturing method of an SONOS-type flash memory in this modification example 3 is substantially the same as that in the modification example 2. However, it is different in that not only the pitch of the insulation portions 61 is narrowed but also the pitch of metal wiring 71 is narrowed.

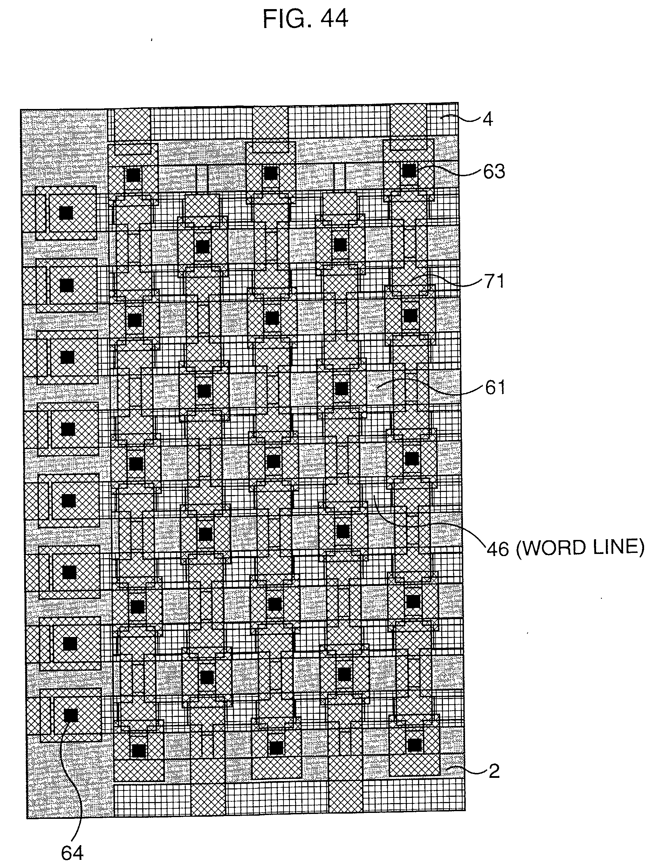

Fig. 44 is a diagrammatic plan view showing a final process of the manufacturing method of the SONOS-type flash memory according to the modification example 3 of the fourth embodiment.

Here, after each process shown in Fig. 36 to Fig. 41 in the modification example 2, oxide film removing processing is performed for the exposed portions of the cobalt silicides 46 in the active regions 3, 4 by dry etching. Thereafter, a metal film made of an Al alloy or the like is formed by a sputtering method. By patterning of this metal film, the metal wiring 71 is formed, which is connected to the bit lines 43 and the word lines 44 (also to the gate electrodes, the sources/drains in the active region 4 of the peripheral circuit) via the contact holes 63, 64 and with which the bit lines 43 are backed. Here, the metal wiring 71 is formed in a manner that the pitch is narrower near the contact hole forming regions 65 compared with the metal wiring 19 of the modification example 2.

Thereafter, after an interlayer insulation film, contact holes (via holes), a wiring layer, and so on are further formed, the SONOS-type flash memory is finished.

According to this modification example 3, in the active region 3 of the memory cell, insulation between the word lines 44 and the cobalt silicides 46 is ensured by the side walls 45. Moreover, the insulation portions 61 are formed between the adjacent bit lines 43 in advance to ensure insulation. Therefore, the memory cell region and its peripheral circuit region are salicided without short-circuit being caused between the adjacent bit lines 43 by the cobalt silicides 45 and wiring resistance is suppressed. Thereby, higher-speed driving of the so-called SONOS-type flash memory is realized.

Moreover, the bit lines 43 can be directly aligned relative to the insulation portions 61. Therefore, there is no need to provide useless covers. Furthermore, a so-called dual gate is made possible by using the siliciding process and a low-voltage operation can also be realized by lowering a threshold (Vth).

One example of comparison of each resistivity of the word lines and the bit lines in the modification example 3 with that in the conventional example will be explained here.

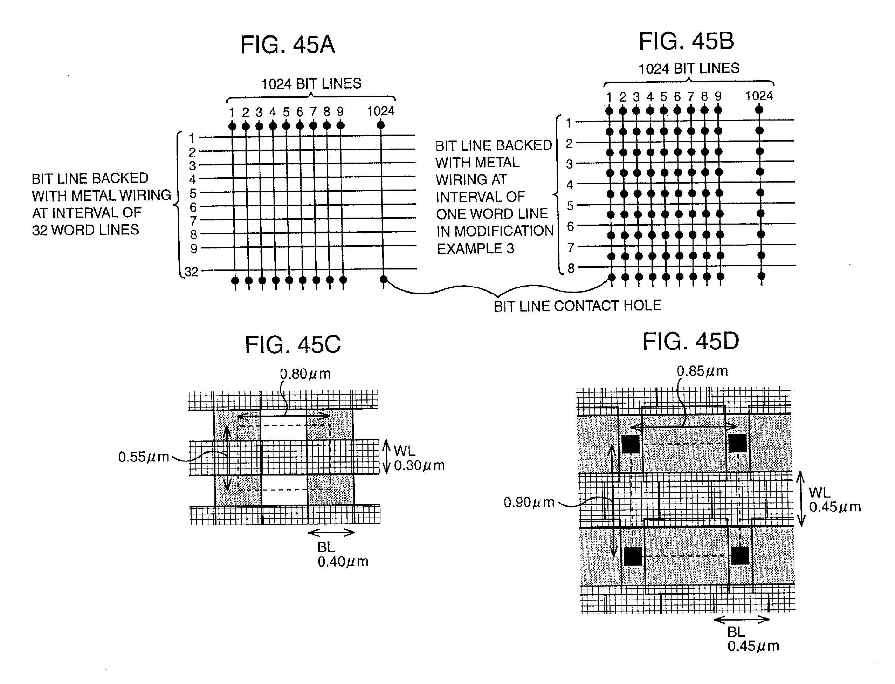

In the conventional example, the bit lines are backed with the metal wiring at intervals of 32 word lines as shown in Fig. 45A. On the other hand, in the modification example 3, the bit lines 43 are backed with the metal wiring 71 at intervals of one word line 43 as shown in Fig. 45B. As a result, taking a case of a so-called 0.25 µm technology for example, the size of the memory cell is 0.55 µm x 0.88 µm in the conventional example as shown in Fig. 45C, and in the modification example 3, it is 0.90 µm 0.85 µm as shown in Fig. 45D. Therefore, the size of the memory cell in the modification example 3 is 74% larger at the maximum compared with that in the conventional example.

On the other hand, the resistivity of the word lines (for 32 word lines) becomes as follows.

### (1) Conventional example

150 kΩ to 300 kΩ for the word lines made of a non-silicided polycrystalline silicon film (60 Ω/□ to 100 Ω/□), and 30 kΩ to 40 kΩ for the word lines made of a polycrystalline silicon film where tungsten silicide is formed (12 Ω/□ to 18 Ω/□)

### (2) Modification example 3

5 kΩ to 15 kΩ for the word lines made of a polycrystalline silicon film where the cobalt silicides are formed (4 Ω/□ to 6 Ω/□),

Meanwhile, the resistivity of the bit lines (for 1024 bit lines) is as follows.

### (1) Conventional example

3 kΩ to 4 kΩ for the bit lines made of an impurity diffused layer (70 Ω/□ to 80 Ω/□)

### (2) Modification example 3

0.15 kΩ to 0.2 kΩ for the bit lines made of an impurity diffused layer where the cobalt silicides are formed (cobalt silicide: 5 Ω/□ to 10 Ω/□, impurity diffused layer: 70 Ω/□ to 80 Ω/□)

As described above, according to the modification example 3, though the size of the memory cell is a little larger, the resistivity of the word lines and the resistivity of the bit lines can be lowered to about 1/20 to about 1/30 and about 1/20 respectively compared with those in the conventional example.

### -Fifth Embodiment-

Next, a fifth embodiment of the present invention will be explained. In this embodiment, a case when the present invention is applied to a floating-gate-type flash memory will be shown as an example. The structure of the flash memory will be explained together with its manufacturing processes here for convenience' sake.

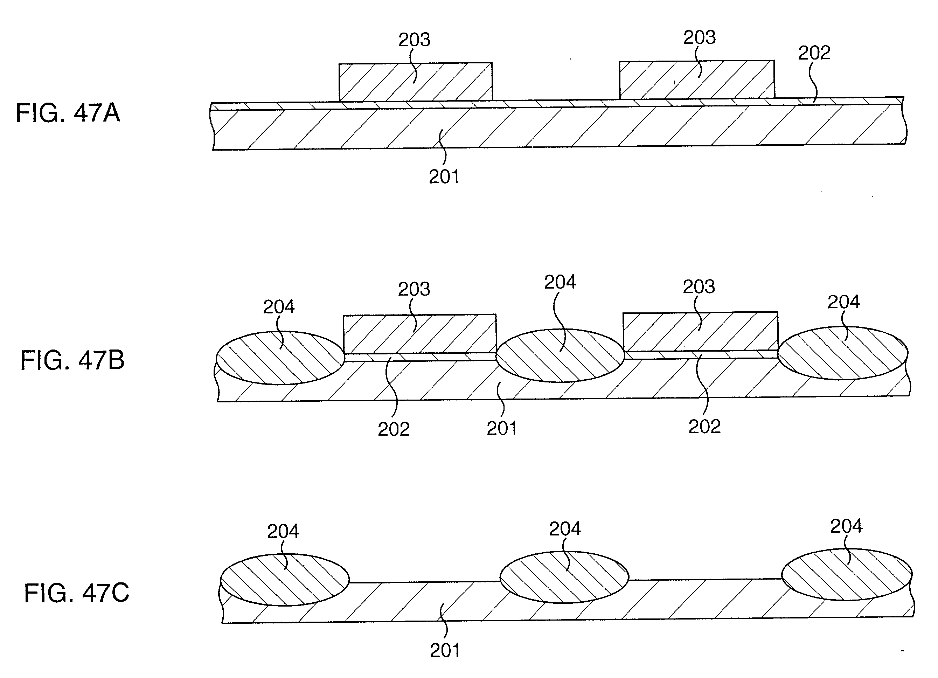

Fig. 47A and Fig. 47B to Fig. 52 are diagrammatic plan views showing a manufacturing method of the floating-gate-type flash memory according to the fifth embodiment in the order of its processes.

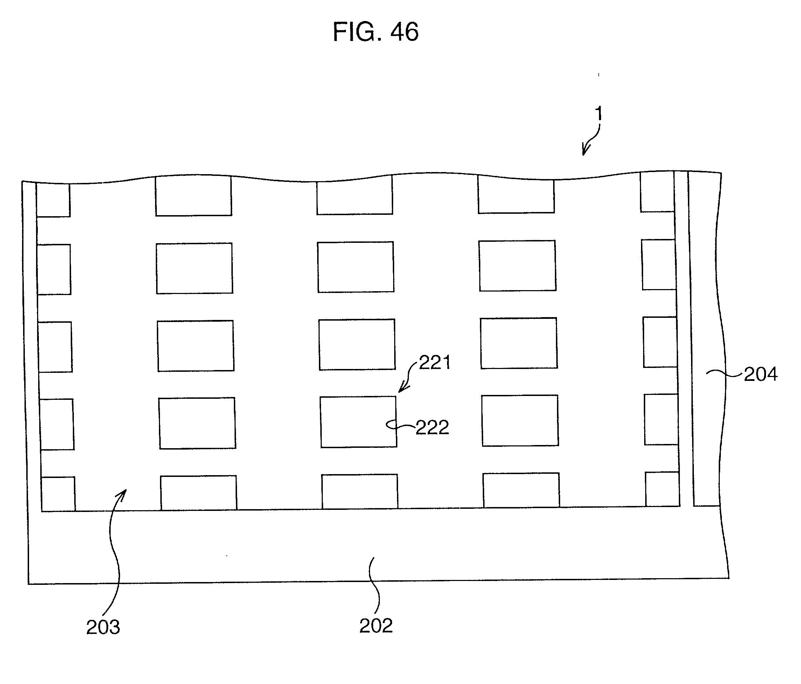

In order to manufacture this flash memory, a p-type silicon semiconductor substrate 201 is first prepared, as shown in Fig. 46. On the surface of this semiconductor substrate 201, a thermal oxide film 202 with a film thickness of about 200 nm to about 500 nm is formed in an element separation region through thermal oxidation at a temperature of 900 °C to 1000 °C, for example, by a LOCOS method. Thereby, element separation is caused and an active region 203 of a memory cell and an active region 204 of a peripheral circuit where a CMOS transistor and so on are formed are demarcated.

In this case, instead of using the LOCOS method, a so-called STI element separating method, in which a trench (not shown) is formed in the element separation region of the semiconductor substrate 201 and an insulator is filled to the trench, may be used to demarcate the active regions.

Subsequently, in matrix portions surrounded by bit lines 211 and word lines 212 in a lattice form in the active region 203, trenches 222 which are about 0.2 µm to about 0.4 µm in depth are formed respectively by patterning. A silicon oxide film thick enough to fill these trenches 222 is deposited by a CVD method. Then, the surface is polished by a chemical mechanical polishing (CMP) method. Thereby, insulation portions 221 which are formed by filling the respective trenches 222 with the silicon oxide film are formed. Incidentally, the insulation portions 221 may be formed as a field oxide film by the so-called LOCOS method.

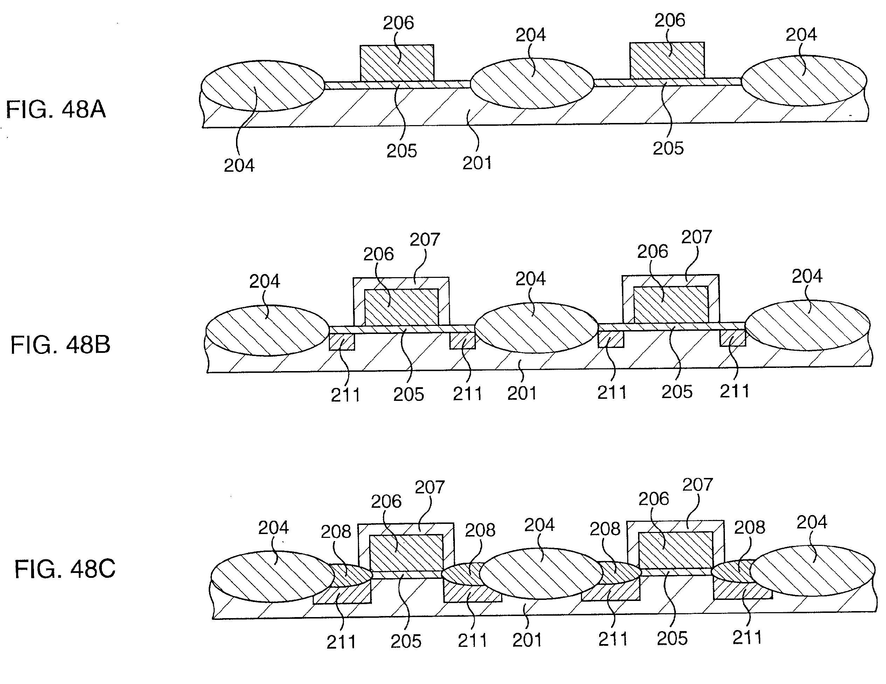

Next, floating-gate electrodes 213 are patterned as shown in Fig. 47A to Fig. 47C and Fig. 48A to Fig. 48C.

More specifically, as shown in Fig. 47A, after the thermal oxide film 202 is first formed on the active region 203 of the memory cell, belt-shaped silicon nitride films 203 are patterned on this thermal oxide film 202.

Subsequently, as shown in Fig. 47B, belt-shaped field oxide films 204 are formed though thermal oxidation by the LOCOS method using the silicon nitride films 203 as masks. Thereafter, as shown in Fig. 47C, the silicon nitride films 203 and the thermal oxide films 202 are removed.

Subsequently, as shown in Fig. 48A, tunnel oxide films 205 are formed by thermal oxidation in the regions demarcated by the field oxide films 204, and thereafter, polycrystalline silicon films 206 are deposited by the CVD method and the polycrystalline silicon films 206 are patterned to be a belt shape along the field oxide films 204.

Subsequently, as shown in Fig. 48B, a silicon nitride film 207 is deposited on the entire surface by the CVD method, and then, the silicon nitride film 207 is patterned to cover only the polycrystalline silicon films 206.

Subsequently, using the silicon nitride films 207 as masks, an n-type impurity, arsenic here, is ion-implanted to the substrate surface on both sides of the polycrystalline silicon films 206 under the condition of a dose amount of 1 x 10¹⁵ to 5 x 10¹⁵ (/cm²) and acceleration energy of 50 to 90 (keV).

Subsequently, as shown in Fig. 48C, the tunnel oxide films 205 exposed by the thermal processing are made thick to form field oxide films 208. In addition, the n-type impurity injected by the thermal processing is activated to form the embedded bit lines 211 which become sources/drains.

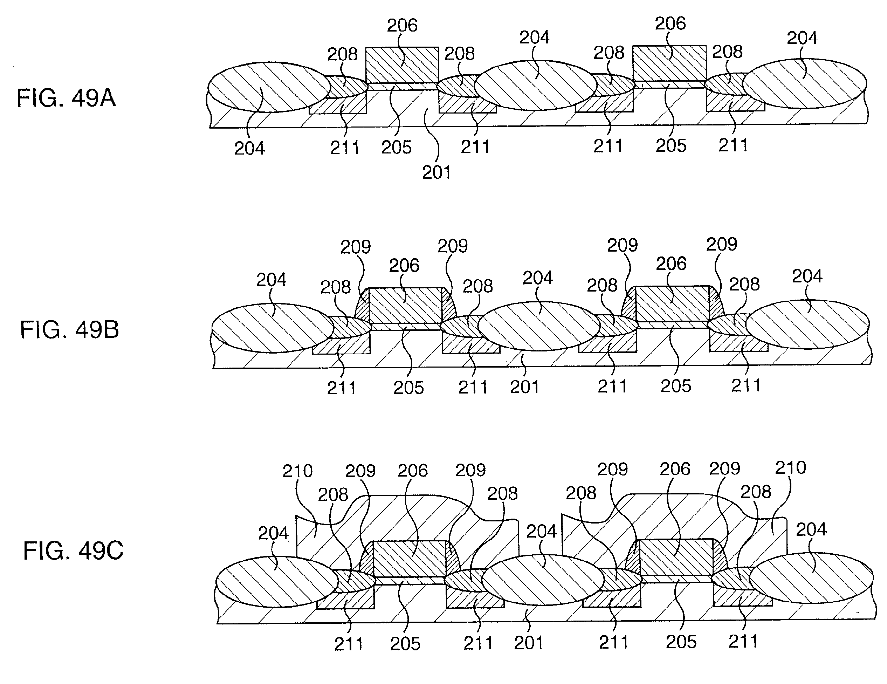

Subsequently, as shown in Fig. 49A, the silicon nitride films 207 are removed. Thereafter, as shown in Fig. 49B, a silicon oxide film is deposited on the entire surface by the CVD method to cover the polycrystalline silicon films 206, and the entire surface of this silicon oxide film is anisotropically etched, so that side walls 209 are formed on side walls of the polycrystalline silicon films 206.

Subsequently, as shown in Fig. 49C, a polycrystalline silicon film 210 is deposited by the CVD method to cover the polycrystalline silicon films 206, and the polycrystalline silicon film 210 is patterned to be divided to portions, each covering a region between the field oxide films 204 so that each portion of the divided polycrystalline silicon film 210 corresponds to each of the polycrystalline silicon film 206. At this time, each of the polycrystalline silicon film 206 and each of the polycrystalline silicon film 210 are integrated with each other.

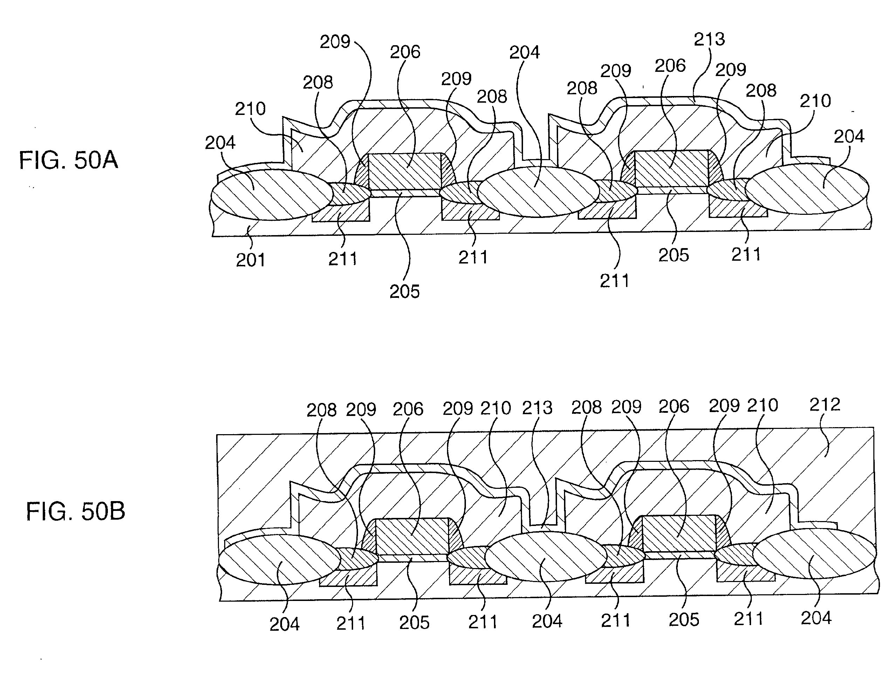

Subsequently, as shown in Fig. 50A, an ONO film 213 which has a three-layered structure composed of an upper silicon oxide film, a silicon nitride film, and a lower silicon oxide film, is formed to cover the polycrystalline silicon films 210.

More specifically, the lower silicon oxide film having a film thickness of about 5 nm to about 10 nm is first formed on the semiconductor substrate 201 by thermal oxidation at a temperature of 800 °C to 1100 °C. Next, the silicon nitride film having a film thickness of about 12 nm to about 16 nm is formed on the lower silicon oxide film by the CVD method at a temperature of 600 °C to 800 °C. Then, the upper silicon oxide film having a film thickness of about 5 nm to about 10 nm is formed on the silicon nitride film by wet oxidation at a temperature of 1000 °C to 1100 °C. These three layers constitute the ONO films 213. Incidentally, when the silicon nitride film is thinned, it is possible to form the upper silicon oxide film by the CVD method.

Subsequently, as shown in Fig. 50B, amorphous silicon doped with phosphorus (P) whose concentration is 3 x 10²¹ (cm³) is deposited on the entire surface by the CVD method until it has a film thickness of about 100 nm to about 150 nm, and a silicon nitride film 221 is formed on this amorphous silicon by a plasma CVD method. In this way, a resist pattern (not shown) in an electrode shape is formed. Using this resist pattern as a mask, the silicon nitride film 221 and the amorphous silicon are dry-etched using HCl/O₂ gas and the like as etching gas. In this way, word lines 212 crossing (in this example, crossing at right angles) the bit lines 211 via the ONO film 213 are formed in the active region 203 of the memory cell, and gate electrodes (not shown) are formed in the active region 204 of the peripheral circuit on the semiconductor substrate 201 via a gate insulation film.

Here, amorphous silicon doped with phosphorus is formed in the above example. However, it is possible to form a dual-gate structure by forming non-doped silicon instead and ion-implanting an n-type impurity and a p-type impurity separately using a resist pattern.

Subsequently, ashing removal is performed for the resist pattern. Thereafter, a resist pattern (not shown) with only n-type transistor regions of the active region 204 of the peripheral circuit left open is formed. Using the gate electrodes as masks, an n-type impurity, arsenic here, is ion-implanted to the surface layer of the semiconductor substrate 201 under the condition of a dose amount of 1 x 10¹³ to 3 x 10¹³ (/cm²) and acceleration energy of 50 to 70 (keV) to form n-type LDDs. Next, a resist pattern (not shown), this time with only p-type transistor regions (n-type wells) of the active region 204 of the peripheral circuit left open is formed. Using the gate electrodes as masks, a p-type impurity, boron (B) here, is ion-implanted to the surface layer of the semiconductor substrate 201 under the condition of a dose amount of 3 x 10¹³ to 7 x 10¹³ (/cm²) and acceleration energy of 20 to 30 (keV) to form p-type LDDs.

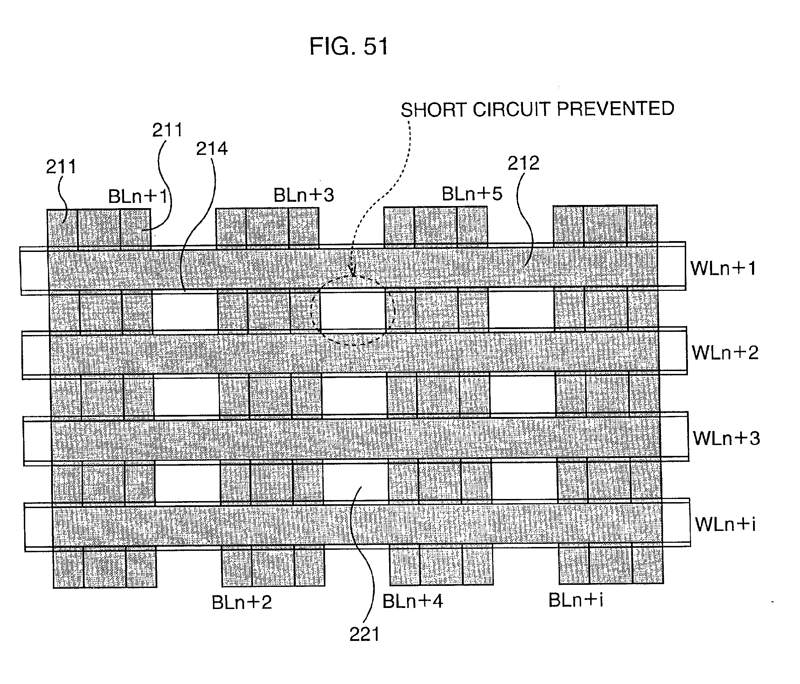

Subsequently, a silicon oxide film is deposited on the entire surface by the CVD method. This silicon oxide film is full-anisotropically etched. Thereby, as shown in Fig. 51, side walls 214 are formed on the side walls of the word lines 212 in the active region 203 of the memory cell. In the active region 204 of the peripheral circuit, side walls (not shown) are formed on the side walls of the gate electrodes. These side walls are for preventing short-circuit between the word lines 211 (gate electrodes) due to siliciding.

Subsequently, a resist pattern (not shown) with only n-type transistor regions of the active region 204 of the peripheral circuit left open is formed. Using the gate electrodes and the side walls as masks, an n-type impurity, arsenic here, is ion-implanted to the surface layer of the semiconductor substrate 201 under the condition of a dose amount of 3 x 10¹⁵ to 5 x 10¹⁵ (/cm²) and acceleration energy of 50 to 70 (keV) to form n-type sources/drains. Next, a resist pattern (not shown), this time with only p-type transistor regions (n-type wells) of the active region 204 of the peripheral circuit left open is formed. Using the gate electrodes and the side walls as masks, a p-type impurity, boron (B) here, is ion-implanted to the surface layer of the semiconductor substrate 201 under the condition of a dose amount of 3 x 10¹⁵ to 5 x 10¹⁵ (/cm²) and acceleration energy of 30 to 50 (keV) to form p-type sources/drains.

The silicon nitride film exposed on the word lines 212 in the active region 203 and on the gate electrodes of the active region 204 are removed by phosphoric acid boiling. Subsequently, the oxide film exposed on the bit lines 211 in the active region 203 and on the sources/drains in the active region 204 are removed by hydrofluoric acid treatment.

Subsequently, on the entire surface, cobalt (Co) is deposited until it has a film thickness of about 5 nm to about 10 nm, and TiN is deposited until it has a film thickness of about 20 nm to about 50 nm by a sputtering method. They are silicided by rapid anneal treatment (RTA) at a temperature of 450 °C to 550 °C. Thereby, the cobalt silicides 215 are formed on the surfaces of the bit lines 211, the surfaces of the word lines 212, and the surfaces of the sources/drains in the active region 204 of the peripheral circuit (only the active region 203 of the memory cell is shown here).

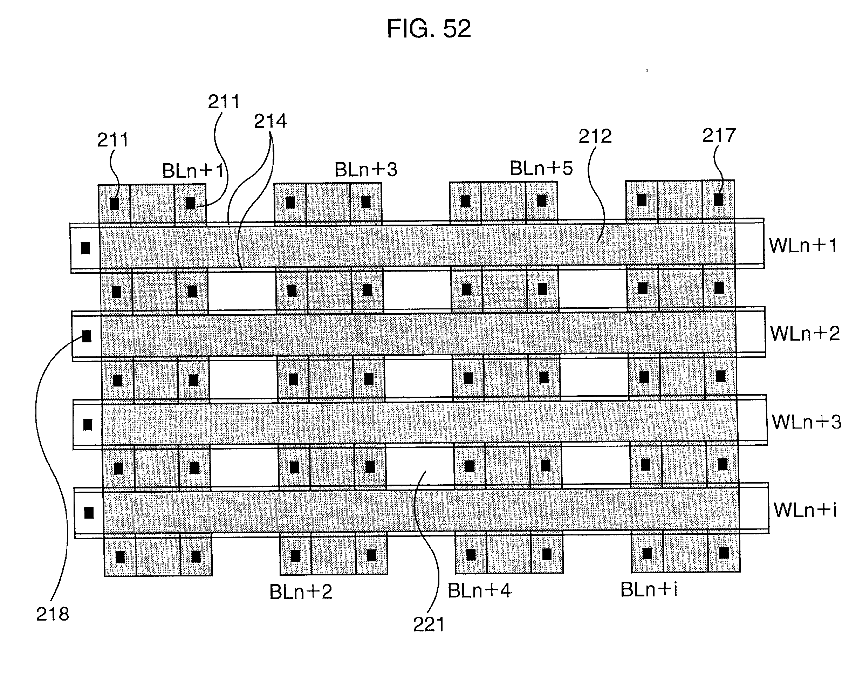

Subsequently, as shown in Fig.52, after an interlayer insulation film is formed on the entire surface, contact holes 217, 218 are formed in connection hole forming regions of the bit lines 211 and connection hole forming regions of the word lines 212 respectively.

Subsequently, similarly to the fourth embodiment, after oxide film removing processing by dry etching is performed for the exposed portions of the cobalt silicides 215 in the active regions 203, 204 as pre-processing of a wiring forming process, a metal film made of an Al alloy or the like is formed by the sputtering method. By patterning of this metal film, metal wiring is formed, which is connected to the bit lines 211 and the word lines 212 (also to the gate electrodes, the sources/drains in the active region 204 of the peripheral circuit) via the contact holes 217, 218 and with which the bit lines 211 are backed.

Thereafter, after an interlayer insulation film, contact holes (via holes), a wiring layer, and so on are further formed, the floating-gate-type flash memory is finished.

According to this embodiment, in the active region 203 of the memory cell, insulation between the word lines 212 and the cobalt silicides 215 is ensured by the side walls 214. Moreover, as shown in Fig. 51, the insulation portions 221 are formed between the adjacent bit lines 211 in advance to ensure insulation. Therefore, the memory cell region and its peripheral circuit region are salicided without short-circuit being caused between the adjacent bit lines 211 by the cobalt silicides 215 and wiring resistance is suppressed. Thereby, higher-speed driving of the so-called floating-gate-type flash memory can be realized.

### -Sixth Embodiment-

Next, a sixth embodiment of the present invention will be explained. In this embodiment, a floating-gate-type flash memory will be explained as an example, similarly to the fifth embodiment. However, this embodiment is different from the fifth embodiment in the form of the insulation regions. Note that the same reference numerals and symbols are used to designate the same components and so on as those explained in the fifth embodiment, and therefore, the explanation thereof will be omitted.

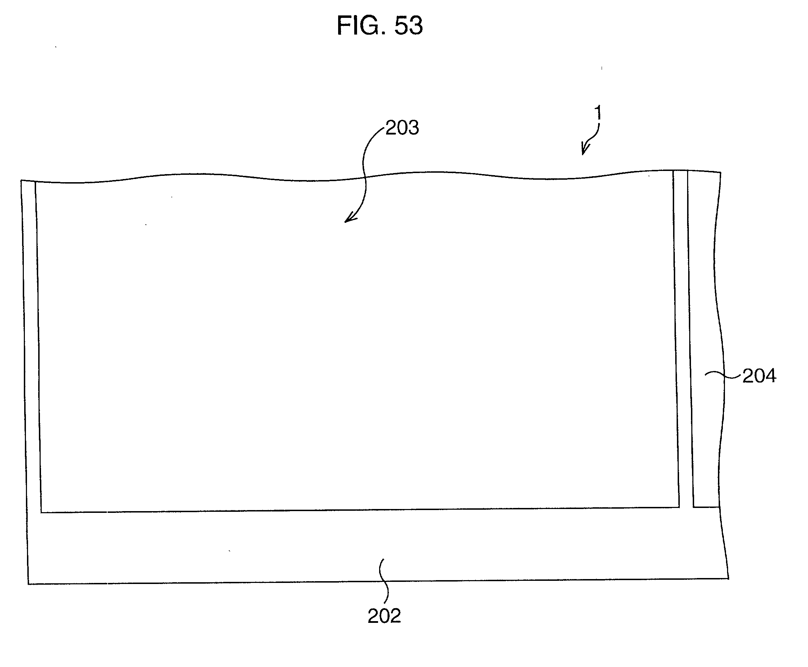

Fig. 53 to Fig. 56 are diagrammatic plan views and a diagrammatic cross sectional view showing a manufacturing method of the floating-gate-type flash memory according to the sixth embodiment in the order of its processes.

In order to manufacture this flash memory, the p-type silicon semiconductor substrate 201 is first prepared, as shown in Fig. 53. On the surface of this semiconductor substrate 201, the thermal oxide film 202 with a film thickness of about 200 nm to about 500 nm is formed in an element separation region through thermal oxidation at a temperature of 900 °C to 1000 °C, for example, by a LOCOS method. Thereby, element separation is caused and the active region 203 of a memory cell and the active region 204 of a peripheral circuit where a CMOS transistor and so on are formed are demarcated.

In this case, instead of using the LOCOS method, a so-called STI element separating method, in which a trench (not shown) is formed in the element separation region of the semiconductor substrate 201 and an insulator is filled to the trench, may be used to demarcate the active regions.

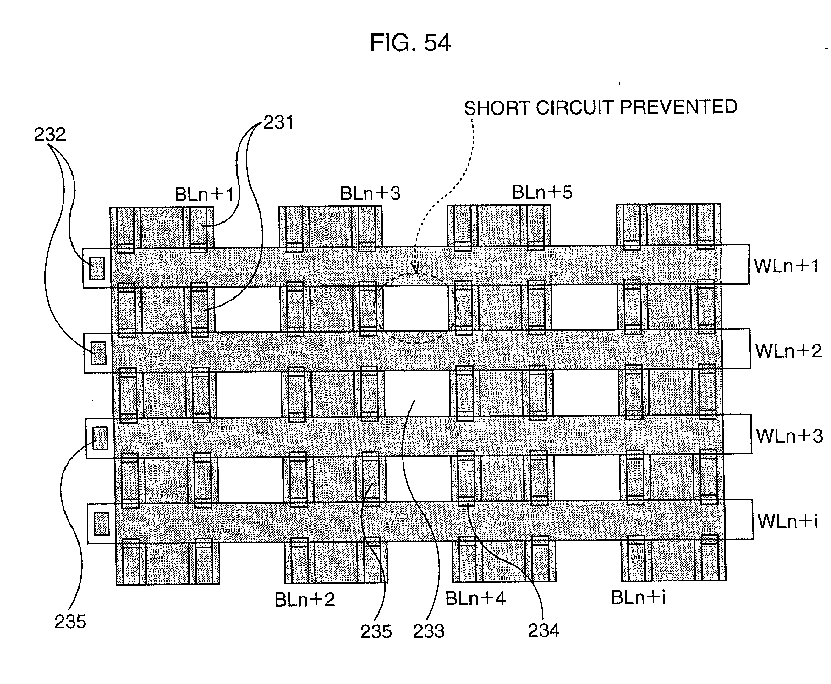

Subsequently, after each process in Fig. 48A to Fig. 50A in the fifth embodiment, as shown in Fig. 54, amorphous silicon doped with phosphorus (P) whose concentration is 3 x 10²¹ (cm³) is deposited on the entire surface until it has a film thickness of about 100 nm to about 150 nm, and tungsten silicide is deposited on this amorphous silicon by a CVD method until it has a film thickness of about 150 nm to about 180 nm. Using this resist pattern as a mask, the tungsten silicide and the amorphous silicon are dry-etched using HCl/O₂ gas and the like as etching gas. In this way, the word lines 212 crossing (in this example, crossing at right angles) the bit lines 211 via the ONO film 213 are formed in the active region 203 of the memory cell, and gate electrodes (not shown) are formed in the active region 204 of the peripheral circuit on the semiconductor substrate 201 via the gate insulation film.

Subsequently, a silicon oxide film is deposited on the entire surface by the CVD method. Then, on this silicon oxide film, a resist pattern (not shown) which is shaped to cover portions necessary for electrical insulation between the adjacent bit lines 211 and to leave metal silicide forming portions open is formed. In other words, here, this resist pattern is shaped to expose only connection hole forming regions 231 where contact holes of the bit lines 211 are formed and connection hole forming regions 232 where contact holes of the word lines 212 are formed. Using this resist pattern as a mask, the silicon oxide film is full-anisotropically etched.

Then, ashing removal is performed for the resist pattern. Thereby, a guard film 233, which is formed of the silicon oxide film, having the connection hole forming regions 231, 232 in which portions of the bit lines 211 are exposed is formed in the active region 203 of the memory cell. At the same time, side walls 234 are formed on the side walls of the word lines 212 facing end portions of the connection hole forming regions 231, 232. In this way, insulation regions are constituted of the guard film 233 and the side walls 234. At this time, side walls (not shown) are also formed on the side walls of the gate electrodes in the active region 204 of the peripheral circuit.

Furthermore, the oxide film formed on the surfaces of the bit lines 211 which are exposed in the connection hole forming regions 231 and on the surfaces of the sources/drains in the active region 204 of the peripheral circuit is removed by hydrofluoric acid treatment. At this time, portions under the insulation regions (under the guard film 233 and the side walls 234 in the active region 203 of the memory cell) and portions under the side walls in the active region 204 of the peripheral circuit are not influenced by the hydrofluoric acid treatment.

Thereafter, titanium (Ti) is deposited on the entire surface by a sputtering method until it has a film thickness of about 20 nm to about 50 nm. Then, it is silicided by rapid anneal treatment (RTA) at a temperature of 650 °C to 750 °C. Thereby, titanium silicides 235 are formed on the surfaces of the bit lines 211 exposed in the connection hole forming regions 231 and on the surfaces of the sources/drains in the active region 204 of the peripheral circuit (only the active region 203 of the memory cell is shown here).

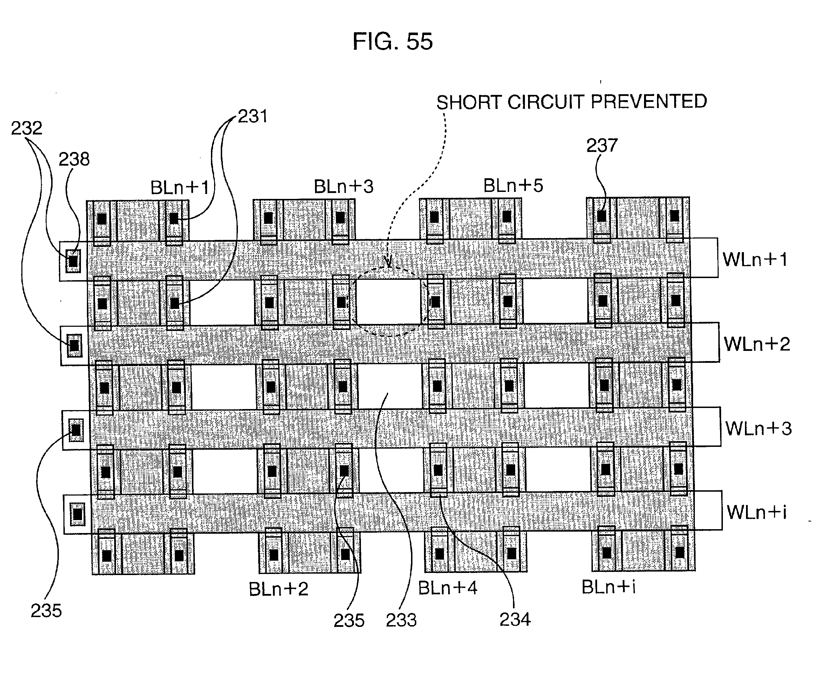

Subsequently, as shown in Fig. 55, after an interlayer insulation film 216 is formed on the entire surface by the CVD method, contact holes 237, 238 are formed in portions of the interlayer insulation film 216 which correspond to the connection hole forming regions 231, 232.

Subsequently, similarly to the fifth embodiment, after oxide film removing processing by dry etching is performed for the portions of the titanium silicides 235 exposed from the guard film 233 as pre-processing of a wiring forming process, a metal film made of an Al alloy or the like is formed by the sputtering method. By patterning of this metal film, metal wiring is formed, which is connected to the bit lines 211 and the word lines 212 (also to the gate electrodes, the sources/drain in the active region 204 of the peripheral circuit) via the contact holes 217, 218 and with which the bit lines 211 are backed. 0182

Thereafter, after an interlayer insulation film, contact holes (via holes), a wiring layer, and so on are further formed, the floating-gate-type flash memory is finished. 0183

According to this embodiment, in the active region 203 of the memory cell, insulation between the word lines 212 and the titanium silicides 235 is ensured by the side walls 214. Moreover, as shown in Fig. 55, the insulation regions 221 are formed between the adjacent bit lines 211 to ensure insulation. Therefore, the memory cell region and its peripheral circuit region are silicided without short-circuit being caused between the adjacent bit lines 211 by the titanium silicides 235 and wiring resistance is suppressed. Thereby, higher-speed driving of the so-called floating-gate-type flash memory is realized.

Incidentally, the present invention is not limited to the embodiments 1 to 6. The present invention is applicable not only to a single-value memory in which stored information is designated as "0", "1", but also to a binary memory and a multivalue memory in which stored information is designated as "00", "01", "10", and "11".

According to the present invention, metal siliciding of bit lines and word lines is realized while preventing short circuit and wiring resistance is suppressed in a semiconductor device in which the bit lines are made of an impurity diffused layer and the word lines are formed to cross the bit lines via an insulation film having a charge-capture function. Thereby, higher-speed driving of a semiconductor memory can be realized.

The present embodiments are to be considered in all respects as illustrative and no restrictive, and all changes which come within the meaning and range of equivalency of the claims are therefore intended to be embraced therein. The invention may be embodied in other specific forms without departing from the essential characteristics thereof.

## Claims

1. A method of manufacturing a semiconductor device, the method comprising the steps of:
forming a bit line made of an impurity diffused layer by injecting an impurity to a surface layer of an active region of a semiconductor substrate;
forming an insulation film having a charge-capture function to cover the active region;
forming a word line on the semiconductor substrate via the insulation film by depositing a silicon film and a first metal silicide film on the insulation film and processing the silicon film, the first metal silicide film, and the insulation film; and
forming an insulation region in advance at least between the bit lines adjacent to each other and forming a second metal silicide film on each exposed portion of the bit line to cause electrical insulation between the adjacent bit lines by the insulation region.

2. A manufacturing method according to claim 1, further comprising the step of:
forming a floating electrode in an island shape under the word line via the insulation film to constitute a capacitor with the word line and the floating electrode.

3. A manufacturing method according to claim 1 or 2, further comprising the steps of:
before forming the second metal silicide film,
patterning, after forming an insulator to cover the active region, the insulation film to have an opening exposing the active region on a bottom portion and to form a side wall on a side wall of the word line in the opening, by anisotropic etching using a resist pattern formed on the insulator to mask a region necessary for the electrical insulation between the bit lines.

4. A manufacturing method according to claim 3,
wherein the opening is formed to expose only each connection hole forming region in which each connection hole of the bit line and the word line is formed.

5. A manufacturing method according to claim 3,
wherein the opening is formed in a lattice form to expose portions on the bit line and the word line in longitudinal directions respectively.

6. A manufacturing method according to claim 3,
wherein the opening is formed to expose a portion on the bit line in a longitudinal direction and to expose a connection hole forming region in which a connection hole of the word line is formed.

7. A method of manufacturing a semiconductor device, the method comprising the steps of:
forming a bit line made of an impurity diffused layer by injecting an impurity to a surface layer of an active region of a semiconductor substrate;
forming an insulation film having a charge-capture function to cover the active region;
forming a word line on the semiconductor substrate via the insulation film by depositing a silicon film on the insulation film and processing the silicon film and the insulation film; and
forming an insulation region in advance at least between the bit lines adjacent to each other and forming a metal silicide film on each of exposed portions of the bit line and the word line to cause electrical insulation between the adjacent bit lines by the insulation region.

8. A manufacturing method according to claim 7, further comprising the step of:
forming a floating electrode in an island shape under the word line via the insulation film to constitute a capacitor with the word line and the floating electrode.

9. A manufacturing method according to claim 7 or 8, further comprising the steps of:
before forming the metal silicide film,
patterning, after forming an insulator to cover the active region, the insulation film to have an opening exposing the active region on a bottom portion and to form a side wall on a side wall of the word line in the opening, by anisotropic etching using a resist pattern formed on the insulator to mask a region necessary for the electrical insulation between the bit lines.

10. A manufacturing method according to claim 9,
wherein the opening is formed to expose only each connection hole forming region in which each connection hole of the bit line and the word line is formed.

11. A manufacturing method according to claim 9,
wherein the opening is formed in a lattice form to expose portions on the bit line and the word line in longitudinal directions respectively.

12. A manufacturing method of the semiconductor device according to claim 9,
wherein the opening is formed to expose a portion on the bit line in a longitudinal direction and to expose a connection hole forming region in which a connection hole of the word line is formed.

13. A manufacturing method according to claim 7, further comprising the step of:
in said step of forming the metal silicide,
forming the insulation region in advance in a portion necessary for the electrical insulation between the bit lines in the active region, and forming the bit line and the word line in this state to form the metal silicide film.

14. A manufacturing method according to claim 13,
wherein the insulation region is formed in a portion surrounded by the bit line and the word line in a lattice form.

15. A manufacturing method according to claim 13,
wherein the insulation region is formed by filling a trench formed in the semiconductor substrate with an insulator.

16. A manufacturing method according to claim 13,
wherein the insulation region is a field oxide film formed by a LOCOS method.

17. A manufacturing method according to any of claims 1 to 16,
wherein the insulation film having the charge-capture function is a laminated layer composed of at least three layers of a nitride film and oxide films sandwiching the nitride film from an upper surface and a bottom surface.

18. A semiconductor device, comprising:
a bit line made of an impurity diffused layer on a surface layer of a semiconductor substrate; and
a word line crossing said bit line via an insulation film having a charge-capture function,
wherein an insulation region is formed at least between said bit lines adjacent to each other, and a metal silicide film is formed on said word line and said bit line to cause electrical insulation between said bit lines adjacent to each other by the insulation region.

19. A semiconductor device according to claim 18, further comprising:
a floating gate in an island shape disposed under said word line via the insulation film and constituting a capacitor together with said word line.

20. A semiconductor device according to claim 18,
wherein the insulation region is formed to cover the active region, with each connection hole forming region in which each connection hole of said bit line and said word line is formed being left open, and to cover a side wall of said word line in the connection hole forming region.

21. A semiconductor device according to claim 18,
wherein the insulation region is formed to cover the active region, with portions on said bit line and said word line being exposed in longitudinal directions respectively, and to cover a side wall of said word line in the exposed portion.

22. A semiconductor device according to claim 18,
wherein the insulation region is formed to cover the active region, with a portion on said bit line being exposed in a longitudinal direction and a connection hole forming region in which a connection hole of said word line is formed being exposed, and to cover a side wall of said word line in the exposed portion.

23. A semiconductor device according to claim 18,
wherein the insulation region is formed on a surface layer of the active region, and
wherein said bit line and said word line are formed on an upper portion of the insulation region.

24. A semiconductor device according to claim 23,
wherein the insulation region is formed in a portion surrounded by said bit line and said word line in a lattice form.

25. A semiconductor device according to claim 23,
wherein the insulation region is formed by filling a trench formed in the semiconductor substrate with an insulator.

26. A semiconductor device according to claim 23,
wherein the insulation region is a field oxide film formed by a LOCOS method.
